# EUROPEAN PATENT APPLICATION

(11) **EP 4 726 083 A1**
(43) Date of publication of application: **15.04.2026**
(21) Application number: 23940647.3
(22) Date of filing: 07.06.2023
(51) Int. Cl.: C30B 29/16, C01G 15/00, C30B 11/06

(54) **DIGALLIUM TRIOXIDE SINGLE CRYSTAL SUBSTRATE, METHOD FOR PRODUCING DIGALLIUM TRIOXIDE SINGLE CRYSTAL, AND METHOD FOR PRODUCING DIGALLIUM TRIOXIDE SINGLE CRYSTAL SUBSTRATE**

(71) Applicant: Sumitomo Electric Industries, Ltd., Osaka-shi, Osaka 541-0041 (JP)
(72) Inventor: ISHIKAWA, Yukio, Osaka-shi, Osaka 541-0041 (JP); TANIZAKI, Keisuke, Osaka-shi, Osaka 541-0041 (JP); HAGI, Yoshiaki, Osaka-shi, Osaka 541-0041 (JP)
(74) Representative: Grünecker Patent- und Rechtsanwälte PartG mbB
(86) International application number: PCT/JP2023/021097
(87) International publication number: WO 2024/252542

(57) **Abstract**

A digallium trioxide single crystal substrate is a digallium trioxide single crystal substrate having a circular main surface, wherein the digallium trioxide single crystal substrate has a diameter of 100 mm or more, the digallium trioxide single crystal substrate has a thickness of 600 µm or more, the digallium trioxide single crystal substrate comprises boron, wherein a concentration of the boron is 4 mass ppm or more and 200 mass ppm or less by glow discharge mass spectrometry.

## Description

### TECHNICAL FIELD

The present disclosure relates to a digallium trioxide single crystal substrate, a method for manufacturing a digallium trioxide single crystal, and a method for manufacturing a digallium trioxide single crystal substrate.

### BACKGROUND ART

Japanese Patent Laying-Open No. 2016-079080 (PTL 1), Japanese Patent Laying-Open No. 2017-193466 (PTL 2), Japanese Patent Laying-Open No. 2020-105069 (PTL 3), Japanese Patent Laying-Open No. 2020-011899 (PTL 4), and Japanese Patent Laying-Open No. 2020-059633 (PTL 5) disclose that a digallium trioxide single crystal (hereinafter, also referred to as the "Ga₂O₃ single crystal") has been grown in an air atmosphere by a vertical boat method, an EFG method (Edge-defined Film-fed Growth method) or the like using a crucible made of a platinum rhodium alloy (hereinafter also referred to as the "Pt-Rh alloy"), or a crucible or die made of a platinum iridium alloy (hereinafter also referred to as the "Pt-Ir alloy"). D. Sajuti et al., Mater. Trans., JIM, 34 (1993), pp. 1195-1199 (NPL 1) discloses feasibility of precipitating, through a solubility difference between B₂O₃ and Ga₂O₃, a Ga₂O₃ single crystal by dissolving digallium trioxide (hereinafter, also referred to as "Ga₂O₃") in boron oxide (hereinafter, also referred to as "B₂O₃") in a liquid state, and then cooling the resultant.

### CITATION LIST

### PATENT LITERATURE

PTL 1: Japanese Patent Laying-Open No. 2016-079080
PTL 2: Japanese Patent Laying-Open No. 2017-193466
PTL 3: Japanese Patent Laying-Open No. 2020-105069
PTL 4: Japanese Patent Laying-Open No. 2020-011899
PTL 5: Japanese Patent Laying-Open No. 2020-059633

### NON PATENT LITERATURE

NPL 1: D. Sajuti et al., Mater. Trans., JIM, 34 (1993), pp. 1195-1199

### SUMMARY OF INVENTION

A digallium trioxide single crystal substrate according to the present disclosure is a digallium trioxide single crystal substrate having a circular main surface. The digallium trioxide single crystal substrate has a diameter of 100 mm or more. The digallium trioxide single crystal substrate has a thickness of 600 µm or more. The digallium trioxide single crystal substrate contains boron. A concentration of the boron is 4 mass ppm or more and 200 mass ppm or less by glow discharge mass spectrometry.

### BRIEF DESCRIPTION OF DRAWINGS

[Fig. 1] Fig. 1 is an explanatory diagram illustrating a main surface of a digallium trioxide single crystal substrate according to a present embodiment.
[Fig. 2] Fig. 2 is an explanatory diagram illustrating 5 measurement points set on the main surface of the digallium trioxide single crystal substrate of Fig. 1 for obtaining nanoindentation hardness.
[Fig. 3] Fig. 3 is an explanatory diagram illustrating Hall measurement sample prepared using a central part of the digallium trioxide single crystal substrate according to the present embodiment for measuring respective properties of specific resistance, a carrier concentration, and electron mobility of the substrate.
[Fig. 4] Fig. 4 is a flowchart illustrating an example of a method for manufacturing a digallium trioxide single crystal substrate, which includes a method for manufacturing a digallium trioxide single crystal according to the present embodiment.
[Fig. 5] Fig. 5 is a schematic diagram illustrating a manufacturing apparatus used in the method for manufacturing a digallium trioxide single crystal according to the present embodiment.
[Fig. 6] Fig. 6 is a graph illustrating a relationship between nanoindentation hardness and fracture load in a digallium trioxide single crystal substrate manufactured in Example.

### DETAILED DESCRIPTION

### [Problem to be Solved by the Present Disclosure]

A Ga₂O₃ single crystal is a crystal with strong cleavage and tends to cleave easily in a specific direction. Therefore, in a process for obtaining a digallium trioxide single crystal substrate (hereinafter also referred to as the "Ga₂O₃ single crystal substrate") from a Ga₂O₃ single crystal, there is a concern that cracking defects may occur in many of such substrates during cutting and outer periphery processing of the Ga₂O₃ single crystal, as well as during transportation after obtaining the substrates, and the like. Accordingly, there is a demand for suppression of the occurrence of cracks in the Ga₂O₃ single crystal substrate. On the other hand, it is known that a gallium arsenide single crystal with boron (B) added as an impurity shows improved strength. When a Ga₂O₃ single crystal is obtained using a crucible or the like disclosed in the aforementioned PTLs 1 to 5, the possibility of B being mixed into the Ga₂O₃ single crystal as an impurity is extremely low. NPL 1, mentioned above, only refers to the feasibility of precipitating a Ga₂O₃ single crystal through the solubility difference between B₂O₃ and Ga₂O₃, and suggests neither any effect of improved strength in the Ga₂O₃ single crystal substrate due to the inclusion of B, nor any effect of suppressing occurrence of cracks in the Ga₂O₃ single crystal substrate.

Considering these points, an object of the present disclosure is to provide a digallium trioxide single crystal substrate, a method for manufacturing a digallium trioxide single crystal, and a method for manufacturing a digallium trioxide single crystal substrate, all capable of suppressing occurrence of cracks.

### [Advantageous Effect of the Present Disclosure]

The present disclosure can provide a digallium trioxide single crystal substrate, a method for manufacturing a digallium trioxide single crystal, and a method for manufacturing a digallium trioxide single crystal substrate, all capable of suppressing occurrence of cracks.

### [Description of Embodiments]

Now, the outline of embodiments of the present disclosure will be described. The present inventors have diligently conducted extensive studies to solve the aforementioned problems, resulting in accomplishing the present disclosure. The present inventors have discovered that by adding a small amount of B to a Ga₂O₃ single crystal in obtaining a Ga₂O₃ single crystal substrate from the Ga₂O₃ single crystal, occurrence of cracks can be suppressed, and have found an appropriate B concentration capable of suppressing occurrence of cracks in the substrate. It has been found, in particular, that B belongs to the same group as gallium (Ga), and hence does not adversely affect electrical properties of the substrate, and thus, the present disclosure has been accomplished.

### Next, embodiments of the present disclosure will be listed and described.

[1] A digallium trioxide single crystal substrate according to one embodiment of the present disclosure is a digallium trioxide single crystal substrate having a circular main surface. The digallium trioxide single crystal substrate has a diameter of 100 mm or more. The digallium trioxide single crystal substrate has a thickness of 600 µm or more. The digallium trioxide single crystal substrate contains boron. A concentration of the boron is 4 mass ppm or more and 200 mass ppm or less by glow discharge mass spectrometry. The digallium trioxide single crystal substrate having these characteristics can suppress occurrence of cracks.
[2] The concentration of the boron is preferably 5 mass ppm or more and 100 mass ppm or less by glow discharge mass spectrometry. Thus, the occurrence of cracks in the digallium trioxide single crystal substrate can be further suppressed.
[3] The main surface is preferably a (001) plane of a digallium trioxide single crystal. The main surface preferably has a central part including a center thereof, and an outer peripheral part surrounding the central part. The outer peripheral part is preferably a chamfered region. In the digallium trioxide single crystal substrate, it is preferable that nanoindentation hardness, as measured at 5 positions on the main surface according to a nanoindentation method using a Berkovich indenter under a condition where a maximum load is 10 mN, and the load is applied in such a manner that an angle of intersection between one side of indentation and a direction of the [100] orientation of the digallium trioxide single crystal projected onto the main surface is 0° or more and 10° or less, is preferably 14.8 GPa or more and 22.0 GPa or less at all the positions. When a length from the center of the main surface to a boundary between the central part and the outer peripheral part is defined as r, two mutually orthogonal axes on the main surface passing through the center correspond respectively to an X axis and a Y axis, and the Y axis corresponds to a b axis of the digallium trioxide single crystal, coordinates (X, Y) of the 5 positions defined by the X axis and Y axis are preferably (0, 0), (r-5, 0), (0, r-5), (-(r-5), 0), and (0, -(r-5)). The unit for the r, and for the X and the Y in the coordinates (X, Y), is preferably mm. Thus, the occurrence of cracks in the digallium trioxide single crystal substrate can be much further suppressed.
[4] The digallium trioxide single crystal substrate may contain either or both of rhodium and iridium in some cases. In such cases, concentrations of both the rhodium and the iridium are preferably 0.1 mass ppm or less by glow discharge mass spectrometry. Thus, the electrical properties of the digallium trioxide single crystal substrate can be prevented from being adversely affected.
[5] Specific resistance of the digallium trioxide single crystal substrate, as measured at 25°C through Hall measurement by Van der Pauw method, is preferably 1.0 × 10⁻³ Ω·cm or more and 2.0 Ω·cm or less. A carrier concentration in the digallium trioxide single crystal substrate, as measured at 25°C through Hall measurement by Van der Pauw method, is preferably 4.0 × 10¹⁷ cm⁻³ or more and 1.4 × 10¹⁹ cm⁻³ or less. Electron mobility of the digallium trioxide single crystal substrate, as measured at 25°C through Hall measurement by Van der Pauw method, is preferably 0.2 cm²/V·s or more and 15000 cm²/V·s or less. Thus, the digallium trioxide single crystal substrate can achieve good electrical properties.
[6] A method for manufacturing a digallium trioxide single crystal according to one embodiment of the present disclosure is performed under an air atmosphere. The manufacturing method includes: providing a single crystal growth apparatus that includes at least a cylindrical crucible and a heating device disposed to surround an outer periphery of the crucible; holding a seed crystal made of the digallium trioxide single crystal at a bottom of the crucible, and holding a block or powdered digallium trioxide polycrystal, an n-type dopant, and boron oxide above the seed crystal within the crucible; melting a portion of the seed crystal by heating the crucible with the heating device, obtaining a solution in which digallium trioxide derived from the portion of the seed crystal and the digallium trioxide polycrystal is dissolved at a first concentration, and the n-type dopant is dissolved at a second concentration in the boron oxide, and contacting the solution with a remaining portion of the seed crystal; and growing a crystal from the solution on the remaining portion of the seed crystal to obtain a digallium trioxide single crystal. The crucible is made of platinum. A boron concentration in the digallium trioxide single crystal is 4 mass ppm or more and 200 mass ppm or less by glow discharge mass spectrometry. Through the method for manufacturing a digallium trioxide single crystal having these characteristics, a digallium trioxide single crystal to be used for manufacturing a digallium trioxide single crystal substrate capable of suppressing occurrence of cracks can be obtained.
[7] A method for manufacturing a digallium trioxide single crystal according to one embodiment of the present disclosure is performed under a nitrogen atmosphere. The manufacturing method includes: providing a single crystal growth apparatus that includes at least a cylindrical crucible and a heating device disposed to surround an outer periphery of the crucible; holding a seed crystal made of the digallium trioxide single crystal at a bottom of the crucible, and holding a block or powdered digallium trioxide polycrystal, an n-type dopant, and boron oxide above the seed crystal within the crucible; melting a portion of the seed crystal by heating the crucible with the heating device, obtain a solution in which digallium trioxide derived from the portion of the seed crystal and the digallium trioxide polycrystal is dissolved at a first concentration, and the n-type dopant is dissolved at a second concentration in the boron oxide, and contacting the solution with a remaining portion of the seed crystal; and growing a crystal from the solution on the remaining portion of the seed crystal to obtain a digallium trioxide single crystal. The crucible is made of pyrolytic boron nitride. A concentration of the boron in the digallium trioxide single crystal is 4 mass ppm or more and 200 mass ppm or less by glow discharge mass spectrometry. Through the method for manufacturing a digallium trioxide single crystal having these characteristics, a digallium trioxide single crystal to be used for manufacturing a digallium trioxide single crystal substrate capable of suppressing occurrence of cracks can be obtained.
[8] The single crystal growth apparatus preferably has a nozzle for introducing the digallium trioxide polycrystal and the n-type dopant into the crucible, and a lid for sealing the crucible. The lid preferably has a hole through which the nozzle is inserted. The growing to obtain a digallium trioxide single crystal preferably includes: sampling, through the nozzle, the solution within the crucible, which is sealed by the lid, to analyze concentrations, in the solution, of the digallium trioxide derived from the portion of the seed crystal and the digallium trioxide polycrystal, and the n-type dopant; introducing, according to a result of analysis about the concentration of the digallium trioxide, the digallium trioxide polycrystal into the solution within the crucible through the nozzle, such that a concentration thereof is within plus or minus 5% of the first concentration; and introducing, according to a result of analysis about the concentration of the n-type dopant, the n-type dopant into the solution within the crucible through the nozzle, such that a concentration thereof is within plus or minus 5% of the second concentration. Thus, a digallium trioxide single crystal to be used for manufacturing a digallium trioxide single crystal substrate capable of suppressing occurrence of cracks can be obtained with a high yield.
[9] A method for manufacturing a digallium trioxide single crystal substrate according to one embodiment of the present disclosure includes: processing the digallium trioxide single crystal obtained by the method for manufacturing a digallium trioxide single crystal described above to obtain a digallium trioxide single crystal substrate having a circular main surface. Through the manufacturing method having these characteristics, a digallium trioxide single crystal substrate capable of suppressing occurrence of cracks can be obtained.
[10] In the digallium trioxide single crystal substrate according to [2], the main surface is preferably a (001) plane of a digallium trioxide single crystal. The main surface preferably has a central part including a center thereof, and an outer peripheral part surrounding the central part. The outer peripheral part is preferably a chamfered region. In the digallium trioxide single crystal substrate, it is preferable that nanoindentation hardness, as measured at 5 positions on the main surface according to a nanoindentation method using a Berkovich indenter under a condition where a maximum load is 10 mN, and a load is applied in such a manner that an angle of intersection between one side of indentation and a direction of a [100] orientation of the digallium trioxide single crystal projected onto the main surface is 0° or more and 10° or less, and is preferably 14.8 GPa or more and 22.0 GPa or less at all the positions. When a length from the center of the main surface to a boundary between the central part and the outer peripheral part is defined as r, two mutually orthogonal axes on the main surface passing through the center correspond respectively to an X axis and a Y axis, and the Y axis corresponds to a b axis of the digallium trioxide single crystal, coordinates (X, Y) of the 5 positions defined by the X axis and Y axis are preferably (0, 0), (r-5, 0), (0, r-5), (-(r-5), 0), and (0, -(r-5)). The unit for the r and for the X and the Y in the coordinates (X, Y), is preferably mm. The digallium trioxide single crystal substrate preferably contains either or both of rhodium and iridium. Concentrations of both the rhodium and the iridium are preferably 0.1 mass ppm or less, by glow discharge mass spectrometry. Specific resistance of the digallium trioxide single crystal substrate, as measured at 25°C through Hall measurement by Van der Pauw method, is preferably 1.0 × 10⁻³ Ω·cm or more and 2.0 Ω·cm or less. A carrier concentration in the digallium trioxide single crystal substrate, as measured at 25°C through Hall measurement by Van der Pauw method, is preferably 4.0 × 10¹⁷ cm⁻³ or more and 1.4 × 10¹⁹ cm⁻³ or less. Electron mobility of the digallium trioxide single crystal substrate, as measured at 25°C through Hall measurement by Van der Pauw method, is preferably 0.2 cm²/V·s or more and 15000 cm²/V·s or less. Thus, the digallium trioxide single crystal substrate can more definitely suppress the occurrence of cracks, and can also possess good electrical properties.

### [Details of Embodiments]

One embodiment according to the present disclosure (hereinafter also referred to as the "present embodiment") will now be described in more details, and it is noted that the present disclosure is not limited by the embodiment. In the following description, reference may be made to the accompanying drawings, and identical or corresponding elements are denoted using the same reference signs herein and the drawings, and the descriptions thereof will not be repeated. Furthermore, in the drawings, the scale is appropriately adjusted to facilitate understanding of each element, and the scale of each element illustrated in the drawings does not necessarily match the actual scale of the element.

Herein, the notation "A to B" means the upper and lower limits of a range (i.e., A or more and B or less), and when A has no unit specified but B does, the unit for A is the same as the unit for B. Besides, when a compound or the like is herein represented by a chemical formula, all conventionally known atomic ratios are included if the atomic ratio is not particularly limited, and the compound or the like should not necessarily be restricted only to those within the stoichiometric range.

Herein, a "main surface" of a digallium trioxide single crystal substrate means both of the two circular surfaces of the digallium trioxide single crystal substrate. In the digallium trioxide single crystal substrate, when at least one of these two surfaces satisfies the claims of the present disclosure, the substrate is considered to fall within the technical scope of the present disclosure. Besides, a "plane" used in the term "in-plane" herein means the "main surface". When a diameter of the digallium trioxide single crystal substrate is stated as "100 mm", it means that the diameter is about 100 mm (e.g., about 95 to 105 mm), or is 4 inches. When the diameter is stated as "150 mm", it means that the diameter is about 150 mm (e.g., about 145 to 155 mm), or is 6 inches. The diameter can be measured using a conventionally known outer diameter measuring instrument such as calipers.

Herein, "nanoindentation hardness" means indentation hardness obtained by performing an instrumented indentation test in accordance with ISO 14577, that is, an international standard that includes a nanoindentation method (Nikenya Ryo, "Method For Evaluating Mechanical Property Using Nanoindenter, Bunseki, 561(2021), pp. 457 - 461). Specifically, it means hardness determined by obtaining a load-displacement curve through an indentation test performed on a prescribed position on the main surface of the digallium trioxide single crystal substrate using a Berkovich indenter in accordance with the nanoindentation method, and analyzing the thus obtained load-displacement curve. The "nanoindentation hardness" is calculated by dividing the maximum load (mN) applied to the digallium trioxide single crystal substrate with the Berkovich indenter by a contact area (mm²) between the Berkovich indenter and the digallium trioxide single crystal substrate at the time of applying the maximum load. The unit for the "nanoindentation hardness" is Pascal (Pa).

Herein, crystallographic description uses [ ] for individual directions, < > for group orientations, ( ) for individual planes, and { } for group planes. Besides, a crystallographic negative index is conventionally represented by "- (bar)" put above a numeral value, but a negative sign is placed before the numeral value herein.

### [Digallium Trioxide Single Crystal Substrate]

A digallium trioxide single crystal substrate (Ga₂O₃ single crystal substrate) according to the present disclosure is a Ga₂O₃ single crystal substrate having a circular main surface. The Ga₂O₃ single crystal substrate has a thickness of 100 mm or more. The Ga₂O₃ single crystal substrate has a thickness of 600 µm or more. The Ga₂O₃ single crystal substrate contains boron. A concentration of the boron is 4 mass ppm or more and 200 mass ppm or less by glow discharge mass spectrometry. The Ga₂O₃ single crystal substrate having these characteristics can suppress occurrence of cracks.

### <Diameter and Thickness>

The diameter of the Ga₂O₃ single crystal substrate is 100 mm or more as described above. In particular, the diameter of the Ga₂O₃ single crystal substrate is preferably 99.5 mm or more and 152.5 mm or less. Such a Ga₂O₃ single crystal substrate is specifically preferably a Ga₂O₃ single crystal substrate having a diameter of 100 mm or 150 mm, namely, a Ga₂O₃ single crystal substrate having a diameter of 4 inches or 6 inches. Thus, a Ga₂O₃ single crystal substrate having a large diameter can achieve a characteristic of being difficult to crack.

The thickness of the Ga₂O₃ single crystal substrate is 600 µm or more as described above. In particular, the thickness of the Ga₂O₃ single crystal substrate is preferably 650 µm or more and 700 µm or less. Thus, a Ga₂O₃ single crystal substrate having a thickness widely employed can achieve a characteristic of being difficult to crack. Regarding the diameter of the Ga₂O₃ single crystal substrate, even if the main surface does not form a geometrically circular shape due to the influence of orientation flat (hereinafter also referred to as "OF"), index flat (hereinafter also referred to as "IF") or the like, the diameter shall be calculated based on the circular shape prior to the formation of the OF, IF or the like. The diameter of the Ga₂O₃ single crystal substrate can be measured using a conventionally known outer diameter measuring instrument such as calipers as described above. The thickness of the Ga₂O₃ single crystal substrate can be measured using a non-contact thickness measuring device (Product Name (Model): "TAP-2H-200XY", manufactured by COMS Corporation). The positioning accuracy of the measuring device is 25 µm. The display resolution of the measuring device is 0.01 µm. The repeatability of the measuring device is 0.01 µm . The measuring device used for measuring the thickness of the Ga₂O₃ single crystal substrate is not limited to the above-described measuring device but other measuring devices can also be used as long as the positioning accuracy, display resolution, and repeatability are equivalent to or better than those of the aforementioned measuring device. Herein, the "thickness of the Ga₂O₃ single crystal substrate" means a thickness at the center of the main surface of the Ga₂O₃ single crystal substrate.

### <Main Surface>

### (Circular Shape)

The Ga₂O₃ single crystal substrate has a circular main surface as described above. Herein, the term "circular shape" used to describe the shape of the main surface includes not only a geometrically circular shape but also shapes of cases where the main surface does not form a geometrically circular shape due to formation of at least one of a notch, OF, or IF on the outer periphery of the main surface as described above. Here, the "shape of cases where the main surface does not form a geometrically circular shape" means a shape of cases where, among line segments extending from any points on the outer periphery of the main surface to the center of the main surface, those extending from any points on the notch, OF, or IF to the center of the main surface are shorter. Besides, the "shape of cases where the main surface does not form a geometrically circular shape" also includes shapes of cases where the lengths of all line segments extending from any points on the outer periphery of the main surface to the center of the main surface are not necessarily the same, due to the shape of a Ga₂O₃ single crystal used as a raw material for the Ga₂O₃ single crystal substrate. In this case, the center of the main surface refers to the position of the centroid thereof, and the diameter of the Ga₂O₃ single crystal substrate refers to a length of the longest line segment among line segments extending from any points on the outer periphery of the Ga₂O₃ single crystal substrate, passing through the center of the main surface, and reaching other points on the outer periphery.

### ((001) Plane of Ga₂O₃ Single Crystal)

The main surface is preferably a (001) plane of a Ga₂O₃ single crystal. A Ga₂O₃ single crystal substrate having the (001) plane of a Ga₂O₃ single crystal as the main surface is easily cracked by external stress, because the (001) plane is generally a plane having strong cleavage, and hence such a substrate is known to be susceptible to fracture. In other words, the present embodiment can suppress the occurrence of cracks in a Ga₂O₃ single crystal substrate having the (001) plane of a Ga₂O₃ single crystal as the main surface.

In the present disclosure, the crystal plane of the main surface is understood to have an accuracy error of ± 0.5°. For example, when the main surface is the "(001) plane" of a Ga₂O₃ single crystal, it means that the main surface could be a (001) just plane, or the main surface could be a plane with an off-angle of -0.5 to +0.5° from the (001) plane. An off-angle from the (001) plane on the main surface of a Ga₂O₃ single crystal substrate can be measured using a conventionally known crystal orientation measuring device (for example, product name (model number): "2991G2", manufactured by Rigaku Corporation).

### (Central Part and Outer Peripheral Part)

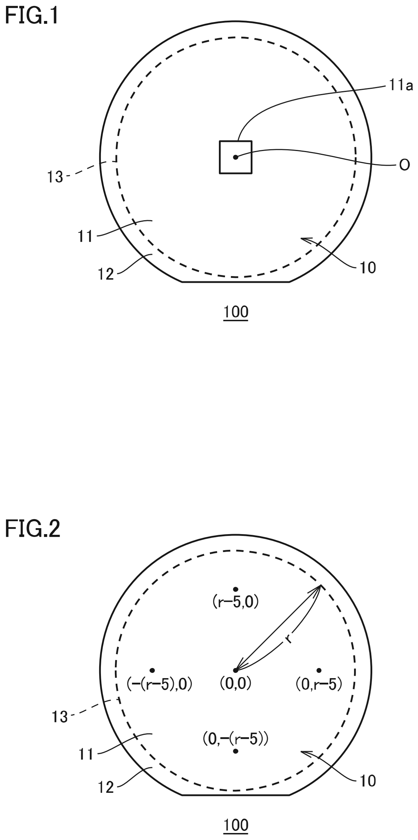

The main surface preferably has a central part including the center thereof, and an outer peripheral part surrounding the central part. The outer peripheral part is preferably a chamfered region. Fig. 1 is an explanatory diagram illustrating the main surface of the digallium trioxide single crystal substrate according to the present embodiment. For example, in a Ga₂O₃ single crystal substrate 100 illustrated in Fig. 1, a main surface 10 has a central part 11 including the center thereof, and an outer peripheral part 12 surrounding the periphery of central part 11. Central part 11 is, in Ga₂O₃ single crystal substrate 100, for example, a region where an epitaxial layer is stacked for constituting an electronic device. Outer peripheral part 12 is a chamfered region. Since outer peripheral part 12 is chamfered, Ga₂O₃ single crystal substrate 100 can reduce instances of cracking and chipping at the outer edge of outer peripheral part 12 during handling. Any conventionally known method can be employed for the chamfering of outer peripheral part 12.

Central part 11 preferably has a circular shape. This makes it possible to represent the length from a center O of main surface 10 to a boundary 13 between central part 11 and outer peripheral part 12 by a single defined value, "r," as will be described later. Here, the term "circular shape" used for describing central part 11 includes not only a geometrically circular shape but also shapes of cases where central part 11 does not form a geometrically circular shape, such as an almost circular shape, due to the chamfering or the like of outer peripheral part 12. In this case, a length r from center O of main surface 10 to boundary 13 between central part 11 and outer peripheral part 12 refers to the length of a shortest line segment among line segments extending from center O of main surface 10 to boundary 13 between central part 11 and outer peripheral part 12. Central part 11 may have a polygonal shape, such as a triangle, a square, or a hexagon.

The width of outer peripheral part 12, namely, the length from the outer edge of outer peripheral part 12 to boundary 13 between central part 11 and outer peripheral part 12, is preferably 2 to 5 mm. This is because the region corresponding to the width of outer peripheral part 12 of Ga₂O₃ single crystal substrate 100 may retain processing strain from the chamfering, and in addition, is known to exhibit significant variations in dislocation count among substrates, and have inferior flatness, and therefore, this region is typically not used as a material for a semiconductor device.

Central part 11 and outer peripheral part 12 are distinguished by a difference in the thickness of Ga₂O₃ single crystal substrate 100 between these parts. The thickness of Ga₂O₃ single crystal substrate 100 in outer peripheral part 12 is less than 99% of the thickness of Ga₂O₃ single crystal substrate 100 in central part 11. In other words, outer peripheral part 12 refers to a chamfered region, as mentioned above, where the thickness therein is less than 99% of the thickness in central part 11. For example, when the thickness in central part 11 is 675 µm, the thickness in outer peripheral part 12 is 668 µm or less. The thicknesses in central part 11 and outer peripheral part 12 can be measured using the non-contact thickness measuring device described above. Also the measuring device used for measuring the thicknesses in central part 11 and outer peripheral part 12 is not limited to the measuring device described above, but other measuring devices can also be used as long as the positioning accuracy, display resolution, and repeatability are equivalent or better. Herein, the "thickness of Ga₂O₃ single crystal substrate 100 in central part 11" means a thickness at center O of main surface 10 of Ga₂O₃ single crystal substrate 100. Thus, "r", that is, the length from center O of main surface 10 to boundary 13 between central part 11 and outer peripheral part 12, can be obtained as a specific numerical value (in mm).

### (Nanoindentation Hardness)

In the Ga₂O₃ single crystal substrate, it is preferable that nanoindentation hardness, as measured at 5 positions on the main surface according to a nanoindentation method using a Berkovich indenter under a condition where a maximum load is 10 mN, and a load is applied in such a manner that an angle of intersection between one side of indentation and a direction of a [100] orientation of the digallium trioxide single crystal projected onto the main surface is 0° or more and 10° or less, and is preferably 14.8 GPa or more and 22.0 GPa or less at all the positions. When a length from the center of the main surface to the boundary between the central part and the outer peripheral part is defined as r, two mutually orthogonal axes on the main surface passing through the center correspond respectively to an X axis and a Y axis, and the Y axis corresponds to a b axis of the digallium trioxide single crystal, coordinates (X, Y) of the 5 positions defined by the X axis and Y axis are preferably (0, 0), (r-5, 0), (0, r-5), (-(r-5), 0), and (0, -(r-5)). The unit for the r and for the X and the Y in the coordinates (X, Y), is preferably mm. The nanoindentation hardness as measured at the 5 positions on the main surface is more preferably 15.0 GPa or more and 21.0 GPa or less at all the positions.

Fig. 2 is an explanatory diagram illustrating 5 measurement points set on the main surface of the digallium trioxide single crystal substrate of Fig. 1 for obtaining the nanoindentation hardness. Now, referring to Fig. 2, a method for measuring the nanoindentation hardness at the 5 positions on main surface 10 by a nanoindentation method using a Berkovich indenter will be described. The measurement method can be performed, for example, using a nanoindenter (product name: "Bruker Hysitron TI980 TriboIndenter," manufactured by Bruker Japan Corporation).

### 1) Preliminary Measurement

Initially, preliminary measurement is performed to ensure that a load can be applied to Ga₂O₃ single crystal substrate 100 in such a manner that an angle of intersection between one side of an indentation of the Berkovich indenter and a direction of the [100] orientation of the Ga₂O₃ single crystal projected onto the main surface is 0° or more and 10° or less. First, Ga₂O₃ single crystal substrate 100 is fixed on a sample stage of the nanoindenter. Next, an optical system equipped in the nanoindenter is used to observe Ga₂O₃ single crystal substrate 100 on the sample stage for, for example, specifying an arbitrary position of central part 11 on main surface 10 as a measurement position. As this measurement position, a position other than the five positions on main surface 10 (i.e., a position not at the coordinates (X, Y) of the 5 positions of (0, 0), (r-5, 0), (0, r-5), (-(r-5), 0), and (0, -(r-5))) is preferably specified to support main measurement described below. Besides, the Berkovich indenter is moved to the specified measurement position, an indentation test is performed with the maximum load of 10 mN, and then Ga₂O₃ single crystal substrate 100 is removed from the sample stage. Thus, the indentation of the Berkovich indenter is formed at the measurement position, and hence, the angle of intersection between one side of the indentation and the [100] orientation of the Ga₂O₃ single crystal constituting Ga₂O₃ single crystal substrate 100 can be obtained. Here, the intersection angle can be obtained by any conventionally known method.

### 2) Main Measurement

Next, main measurement for obtaining the nanoindentation hardness is performed. When the intersection angle obtained in the preliminary measurement is 0° or more and 10° or less, Ga₂O₃ single crystal substrate 100 is fixed on the sample stage in the same orientation as in the preliminary test. When the intersection angle obtained in the preliminary measurement is more than 10°, the orientation of Ga₂O₃ single crystal substrate 100 is adjusted so that the intersection angle can be 0° or more and 10° or less, and then Ga₂O₃ single crystal substrate 100 is fixed on the sample stage. Besides, the optical system equipped in the nanoindenter is used to observe Ga₂O₃ single crystal substrate 100 on the sample stage for, for example, specifying the coordinates (X, Y) of one of the 5 positions on main surface 10 as a measurement position (e.g., (0, 0)). Subsequently, the Berkovich indenter is moved to the measurement position (e.g., (0, 0)), an indentation test is performed with the maximum load of 10 mN, and then Ga₂O₃ single crystal substrate 100 is removed from the sample stage. Thus, an indentation of the Berkovich indenter is formed at the measurement position. Accordingly, based on the indentation, an area (mm²) where the Berkovich indenter contacts Ga₂O₃ single crystal substrate 100 at the time of applying the maximum load of 10 mN can be calculated, and by dividing the maximum load of 10 mN by the area (mm²), the nanoindentation hardness at the measurement position (e.g., (0, 0)) can be obtained.

Subsequently, the coordinates (X, Y) of the remaining of the five positions on main surface 10 (e.g., (r-5, 0), (0, r-5), (-(r-5), 0), and (0, -(r-5))) are respectively specified as the measurement positions. Thereafter, the indentation test and prescribed calculation are performed in the same manner as described above in specifying (0, 0) as the measurement position, and thus, nanoindentation hardness at the coordinates (X, Y) of the remaining of the five positions on main surface 10 can be obtained.

Here, the nanoindentation hardness is indentation hardness obtained by performing an indentation test with a maximum load of 10 mN. When an indentation test is performed with a maximum load of 10 mN, the Berkovich indenter is believed to be pushed comparatively deep into the Ga₂O₃ single crystal substrate, forming an indentation. Therefore, the nanoindentation hardness can be considered to reflect the indentation hardness of the inside of the Ga₂O₃ single crystal substrate.

### <Boron (B)>

The Ga₂O₃ single crystal substrate contains boron (B) as described above. The B concentration is 4 mass ppm or more and 200 mass ppm or less, as measured by glow discharge mass spectrometry (GDMS). When the B concentration by GDMS is less than 4 mass ppm, an effect of improving strength due to inclusion of B might not be sufficient for resisting external stresses applied during processing, transportation, and the like. When the B concentration by GDMS is more than 200 mass ppm, there is a risk that the Ga₂O₃ single crystal substrate could be easily cracked because B might cluster within the Ga₂O₃ single crystal, or residual strain could become excessively large due to thermal history during crystal growth. The B concentration by GDMS is preferably 5 mass ppm or more and 100 mass ppm or less. The B concentration by GDMS is more preferably 50 mass ppm or more and 100 mass ppm or less.

The present inventors hypothesize the following reason why the Ga₂O₃ single crystal substrate, when containing boron at the aforementioned concentration, possesses appropriate hardness, and improved strength, and thus suppresses occurrence of cracks. Specifically, when B is contained in the Ga₂O₃ single crystal at the aforementioned concentration, it is believed that B can exist as an isolated substitutional type in a Ga site within the crystal lattice constituting the single crystal. In this case, a solid solution strengthening effect from B is expected. In particular, when the B concentration is 4 mass ppm or more, it is presumed that sufficient strength for resisting external stresses applied during processing, transportation, and the like can be achieved based on the above-described effect. On the other hand, when the concentration is 200 mass ppm or less, it is presumed that B will not cluster within the Ga₂O₃ single crystal, or the strength will not become excessively high, and hence excessive increase of residual strain caused by thermal history during crystal growth can be avoided. This probably allows B to fully exhibit the effect of reducing susceptibility to cracking in the Ga₂O₃ single crystal substrate.

### (Glow Discharge Mass Spectrometry (GDMS))

Now, a method for measuring the B concentration in the Ga₂O₃ single crystal substrate by glow discharge mass spectrometry (GDMS) will be described. GDMS refers to a method in which a glow discharge plasma is generated with an analytical sample used as a cathode in a high-purity argon atmosphere to sputter a surface of the analytical sample within the plasma, thereby measuring ionized constituent elements of the analytical sample with a mass spectrometer. By this method, it is possible to perform qualitative and quantitative analysis of impurity elements, including B, that are contained in the Ga₂O₃ single crystal substrate in addition to Ga and O. As an ion source in GDMS, either a flat cell or a pin cell is applied. A pin cell can be applied to an analytical sample that can be formed into a strip shape, approximately 2 mm square and 20 mm in length. Specifically, it is used to analyze a sample that can be prepared by cleavage, such as a Si single crystal, a gallium arsenide (GaAs) single crystal, and an indium phosphide (InP) single crystal. A flat cell can be applied to an analytical sample that can be formed into a disc shape with a diameter of about 10 mm, and is used, for example, for analysis of a polycrystal or the like. In any case, from the viewpoint of avoiding external contamination of the analytical sample with impurity elements, it is preferable to select either a flat cell or a pin cell as the ion source for GDMS. When the Ga₂O₃ single crystal substrate has a main surface with the (001) orientation, an analytical sample can be prepared by cleavage in one direction, and therefore, it is preferable to prepare an analytical sample from the Ga₂O₃ single crystal substrate in the shape of a pin cell with the longitudinal direction as the cleavage plane, and to use the resultant as the ion source for GDMS.

The GDMS can be performed, for example, according to the following procedure. First, a Ga₂O₃ single crystal substrate is obtained by a manufacturing method described later. The Ga₂O₃ single crystal substrate is cleaved to form a strip-shaped Ga₂O₃ analytical sample in a size of 2 mm square and 20 mm in length. The directions where cleavage is not performed are cut by a known method using a precision hand grinder or the like. The resultant is placed in a sample holder attached to a device described below. Here, it is preferable that the sample holder is cleaned according to a conventional method for preventing mixture of foreign matters and removing foreign matters, and is pre-sputtered for 60 minutes.

Next, GDMS can be performed on the Ga₂O₃ analytical sample placed on the sample holder under the following conditions. Regarding B, that is, an element contained in addition to Ga and O among the constituent elements in the Ga₂O₃ analytical sample, a semi-quantitative value can be calculated by correcting an ion intensity ratio between Ga and B with a relative sensitivity factor (RSF). As the relative sensitivity factor, a built-in value of software accompanying the following device can be used.
Apparatus: glow discharge mass spectrometer (product name (model number): VG-9000, manufactured by VG Elemental)
Ion source: pin cell (cooled with liquid nitrogen during analysis)
Discharge area: 10 mm diameter
Discharge gas: high-purity argon (6N grade)
Discharge conditions: 2 mA, 1 kV (constant current mode)
Detector: Faraday cup and multiplier
Mass resolution: m/Δm of 4000 or more (high-resolution mode)

By analyzing the Ga₂O₃ analytical sample as described above, B contained in the Ga₂O₃ single crystal substrate can be qualitatively and quantitatively determined. A detection limit concentration for this GDMS is preferably 0.01 mass ppm.

### <Rhodium (Rh) and Iridium (Ir)>

The Ga₂O₃ single crystal substrate contains either or both of rhodium (Rh) and iridium (Ir) in some cases. In such cases, concentrations of both the Rh and the Ir are preferably 0.1 mass ppm or less by GDMS. The concentrations of both the Rh and the Ir are more preferably 0.01 mass ppm or less by GDMS. The lower limits of the Rh concentration and the Ir concentration are such that these are not detected by GDMS. When the concentrations of the Rh and Ir fall in the above-described range, the electrical properties can be prevented from being adversely affected.

The Rh and the Ir are known as elements that may be contained in the Ga₂O₃ single crystal substrate. On the other hand, in manufacturing the Ga₂O₃ single crystal substrate by a method for manufacturing a Ga₂O₃ single crystal substrate described below, by using a crucible made of platinum or pyrolytic boron nitride, both the Rh concentration and the Ir concentration can be easily reduced to 0.1 mass ppm or less by GDMS. The Ga₂O₃ single crystal substrate can suppress the occurrence of cracks, and can have excellent electrical properties due to the low concentrations of the Rh and the Ir.

### (Specific Resistance)

In the Ga₂O₃ single crystal substrate according to the present embodiment, specific resistance of the digallium trioxide single crystal substrate, as measured at 25°C through Hall measurement by Van der Pauw method, is preferably 1.0 × 10⁻³ Ω·cm or more and 2.0 Ω·cm or less. Specifically, it is preferable that the specific resistance, as measured at 25°C through Hall measurement by the Van der Pauw method with the center of the Ga₂O₃ single crystal substrate as a measurement target, shows a value of 1.0 × 10⁻³ Ω·cm or more and 2.0 Ω·cm or less. Thus, as an n-type (electron-donating) Ga₂O₃ single crystal substrate, the substrate can possess excellent electrical properties, thereby contributing to formation of an electronic device. In the Ga₂O₃ single crystal substrate, if the specific resistance is less than 1.0 × 10⁻³ Ω·cm, when a Schottky barrier diode is prepared using the Ga₂O₃ single crystal substrate, there is a risk that a reverse current may increase, leading to a deterioration in breakdown voltage and thermal runaway. When the specific resistance is more than 2.0 Q-cm, there is a risk that a forward voltage may be too high to reduce efficiency. The specific resistance is preferably 5.0 × 10⁻³ Ω·cm or more and 1.0 × 10⁻¹ Ω·cm or less.

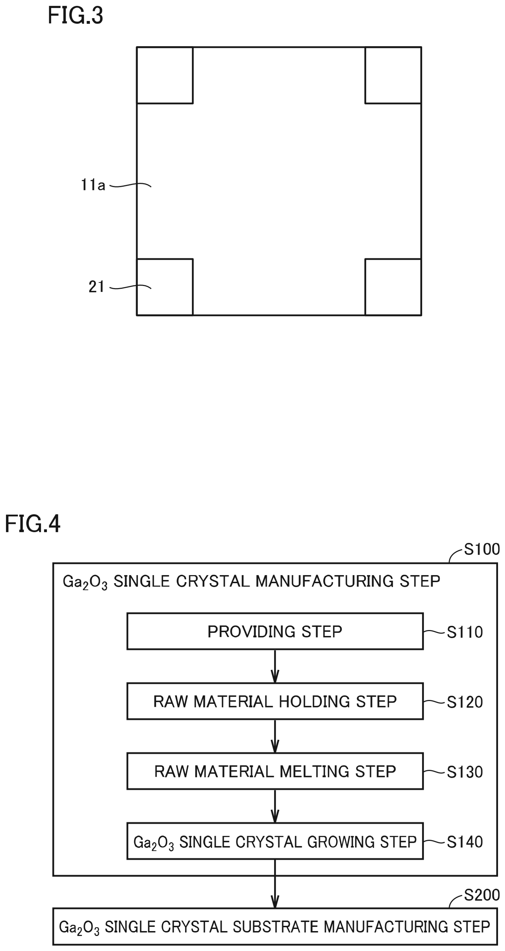

Now, referring to Fig. 1 and Fig. 3, a procedure for obtaining the specific resistance will be specifically described. Fig. 3 is an explanatory diagram illustrating a Hall measurement sample prepared using the central part of the digallium trioxide single crystal substrate according to the present embodiment for measuring respective properties of specific resistance, carrier concentration, and electron mobility of the substrate. First, as illustrated in Fig. 1, one Ga₂O₃ single crystal substrate 100 to be used as a measurement target is obtained by applying a conventionally known processing method to a Ga₂O₃ single crystal obtained, for example, based on a manufacturing method described later. From a central part of one Ga₂O₃ single crystal substrate 100, a rectangular section 11a (for example, with a thickness of 600 µm) having the center thereof (for example, the center of main surface 10) as a center O, and having a size of 10 mm in length × 10 mm in width is prepared. Subsequently, as illustrated in Fig. 3, electrodes 21 of gold are formed at the four corners of rectangular section 11a (on a measurement surface), and thus, a Hall measurement sample is obtained. Here, the shape of the electrodes 21 is not limited to the rectangle as illustrated but can be a fan or circular shape. By applying Hall measurement by the Van der Pauw method to rectangular section 11a having such electrodes 21 in an atmosphere of 25°C, the specific resistance can be obtained. Herein, the specific resistance obtained based on the rectangular section used as the measurement target is defined as the specific resistance of the Ga₂O₃ single crystal substrate as measured at 25°C through Hall measurement by the Van der Pauw method.

### (Carrier Concentration and Electron Mobility)

In the present embodiment, a carrier concentration in the Ga₂O₃ single crystal substrate, as measured at 25°C through Hall measurement by Van der Pauw method, is preferably 4.0 × 10¹⁷ cm⁻³ or more and 1.4 × 10¹⁹ cm⁻³ or less. Electron mobility of the Ga₂O₃ single crystal substrate, as measured at 25°C through Hall measurement by Van der Pauw method, is preferably 0.2 cm²/V·s or more and 15000 cm²/V·s or less. Simultaneously, if the carrier concentration in the Ga₂O₃ single crystal substrate is less than 4.0 × 10¹⁷ cm⁻³, when a Schottky barrier diode is prepared using the Ga₂O₃ single crystal substrate, there is a risk of increase in power loss. If the carrier concentration in the Ga₂O₃ single crystal substrate is more than 1.4 × 10¹⁹ cm⁻³, when a Schottky barrier diode is prepared from the Ga₂O₃ single crystal substrate, there is a risk that a reverse current may increase, leading to a deterioration in breakdown voltage and thermal runaway. By controlling the carrier concentration and the electron mobility respectively to the aforementioned ranges in the Ga₂O₃ single crystal substrate, preferable specific resistance within the above-described range can be achieved.

In particular, the carrier concentration is more preferably 4.5 × 10¹⁷ cm⁻³ or more and 4.0 × 10¹⁸ cm⁻³ or less. The electron mobility is more preferably 10 cm²/V·s or more and 1500 cm²/V·s or less. Thus, the n-type Ga₂O₃ single crystal substrate can possess excellent electrical properties that allow for versatile application in various electronic devices. Both the carrier concentration and the electron mobility can be obtained by the same method as the method for measuring specific resistance described above.

### <Applications>

Owing to the characteristics described above, the Ga₂O₃ single crystal substrate according to the present embodiment can be applied as a substrate for forming an optical device or an electronic device. In particular, the Ga₂O₃ single crystal substrate has good electrical properties, and hence is preferably applied as a substrate for forming an electronic device.

### [Method for Manufacturing Digallium Trioxide Single Crystal]

A method for manufacturing a digallium trioxide single crystal (Ga₂O₃ single crystal) according to the present embodiment is, for example, preferably a method for manufacturing a Ga₂O₃ single crystal constituting the above-described Ga₂O₃ single crystal substrate having a circular main surface. For example, the method for manufacturing a Ga₂O₃ single crystal is performed under an air atmosphere, and may include the following steps. Specifically, the manufacturing method includes: providing a single crystal growth apparatus (hereinafter, also referred to as the "Ga₂O₃ single crystal growth apparatus") that includes at least a cylindrical crucible and a heating device disposed to surround an outer periphery of the crucible; holding a seed crystal made of the Ga₂O₃ single crystal at a bottom of the crucible, and holding a block or powdered digallium trioxide polycrystal (Ga₂O₃ polycrystal), an n-type dopant, and boron oxide (B₂O₃) above the seed crystal within the crucible; melting a portion of the seed crystal by heating the crucible with the heating device, obtaining a solution in which Ga₂O₃ derived from the portion of the seed crystal and the Ga₂O₃ polycrystal is dissolved at a first concentration, and the n-type dopant is dissolved at a second concentration in the B₂O₃, and contacting the solution with a remaining portion of the seed crystal; and growing a crystal from the solution on the remaining portion of the seed crystal to obtain a Ga₂O₃ single crystal. The crucible is made of platinum. A boron concentration in the digallium trioxide single crystal is 4 mass ppm or more and 200 mass ppm or less by GDMS. Through the method for manufacturing a Ga₂O₃ single crystal having these characteristics, a Ga₂O₃ single crystal to be used for manufacturing a Ga₂O₃ single crystal substrate capable of suppressing occurrence of cracks can be obtained.

Alternatively, in the method for manufacturing a Ga₂O₃ single crystal, the steps described above may be performed in a nitrogen atmosphere. Specifically, the method for manufacturing a Ga₂O₃ single crystal is performed in a nitrogen atmosphere, and may include the following steps. The manufacturing method includes: providing a single crystal growth apparatus (hereinafter, also referred to as the "Ga₂O₃ single crystal growth apparatus") that includes at least a cylindrical crucible and a heating device disposed to surround an outer periphery of the crucible; holding a seed crystal made of the Ga₂O₃ single crystal at a bottom of the crucible, and holding a block or powdered Ga₂O₃ polycrystal, an n-type dopant, and B₂O₃ above the seed crystal within the crucible; melting a portion of the seed crystal by heating the crucible with the heating device, obtaining a solution in which Ga₂O₃ derived from the portion of the seed crystal and the Ga₂O₃ polycrystal is dissolved at a first concentration, and the n-type dopant is dissolved at a second concentration in the B₂O₃, and contacting the solution with a remaining portion of the seed crystal; and growing a crystal from the solution on the remaining portion of the seed crystal to obtain a Ga₂O₃ single crystal. The crucible used in this embodiment is made of pyrolytic boron nitride (pBN). A boron concentration in the digallium trioxide single crystal is 4 mass ppm or more and 200 mass ppm or less by GDMS. Also through the method for manufacturing a Ga₂O₃ single crystal having these characteristics, a Ga₂O₃ single crystal to be used for manufacturing a Ga₂O₃ single crystal substrate capable of suppressing occurrence of cracks can be obtained.

Fig. 4 is a flowchart illustrating an example of a method for manufacturing a digallium trioxide single crystal substrate, which includes the method for manufacturing a digallium trioxide single crystal of the present embodiment. The method for manufacturing a Ga₂O₃ single crystal according to the present embodiment is preferably included, for example, as a Ga₂O₃ single crystal manufacturing step S100 illustrated in the flowchart of Fig. 4 in the method for manufacturing a Ga₂O₃ single crystal substrate. Referring to Fig. 4, the method for manufacturing a Ga₂O₃ single crystal substrate of the present embodiment includes Ga₂O₃ single crystal manufacturing step S100, and a Ga₂O₃ single crystal substrate manufacturing step S200. Ga₂O₃ single crystal manufacturing step S100 includes providing a Ga₂O₃ single crystal growth apparatus that includes at least a cylindrical crucible and a heating device disposed to surround an outer periphery of the crucible (first step: providing step S110). In providing step S110, a seed crystal made of the Ga₂O₃ single crystal, a block or powdered Ga₂O₃ polycrystal, an n-type dopant, and solid B₂O₃ are preferably provided in addition to the Ga₂O₃ single crystal growth apparatus. Ga₂O₃ single crystal manufacturing step S100 includes holding the seed crystal at a bottom of the crucible, and holding the Ga₂O₃ polycrystal, the n-type dopant, and the B₂O₃ above the seed crystal within the crucible (second step: raw material holding step S120). Ga₂O₃ single crystal manufacturing step S100 includes a step of melting a portion of the seed crystal by heating the crucible with the heating device, obtaining a solution in which Ga₂O₃ derived from the portion of the seed crystal and the Ga₂O₃ polycrystal is dissolved at a first concentration, and the n-type dopant is dissolved at a second concentration in the B₂O₃, and contacting the solution with a remaining portion of the seed crystal (third step: raw material melting step S130). Ga₂O₃ single crystal manufacturing step S100 further includes growing a crystal from the solution on the remaining portion of the seed crystal to obtain a Ga₂O₃ single crystal (fourth step: Ga₂O₃ single crystal growing step S140). An atmosphere in which Ga₂O₃ single crystal growing step S140 is carried out may be either a nitrogen atmosphere or an air atmosphere, depending on the material of the crucible.

The present inventors focused on, regarding a method for growing a Ga₂O₃ single crystal constituting a Ga₂O₃ single crystal substrate having the aforementioned properties, that after dissolving Ga₂O₃ in liquid B₂O₃ within a crucible, the resultant is cooled to precipitate and obtain a Ga₂O₃ single crystal through a solubility difference between the B₂O₃ and the Ga₂O₃. It has been found, in this case, that a small amount of B₂O₃ is incorporated into the precipitated Ga₂O₃ single crystal. Besides, it has been found that when a Ga₂O₃ single crystal substrate is obtained from a Ga₂O₃ single crystal containing B at a prescribed concentration, the occurrence of cracks in that Ga₂O₃ single crystal substrate is suppressed, and thus, the method for manufacturing a Ga₂O₃ single crystal according to the present embodiment has been achieved.

Herein, "n-type dopant" refers to an oxide of an element that, when contained as a dopant in a Ga₂O₃ single crystal substrate, can impart n-type (electron-donating) properties as the conductivity type to the Ga₂O₃ single crystal substrate. Examples of the element that can impart n-type (electron-donating) properties to the Ga₂O₃ single crystal substrate include tin (Sn), silicon (Si), and germanium (Ge).

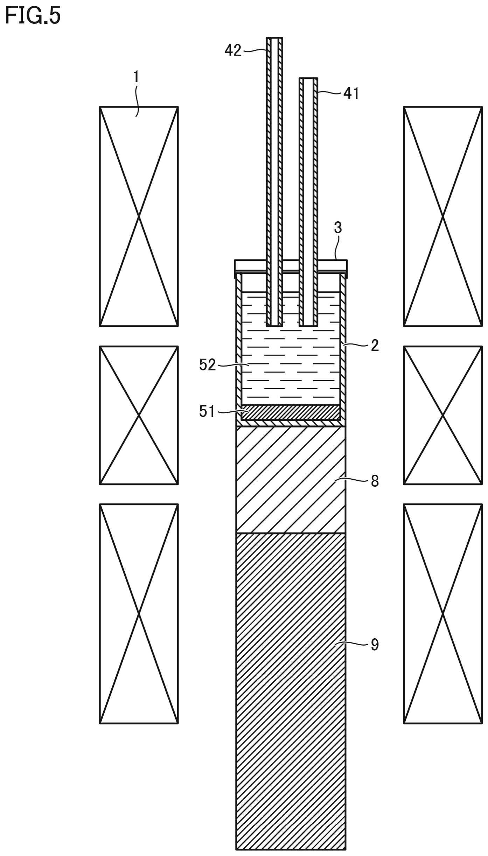

Now, referring to Fig. 4 and Fig. 5, the outline of the Ga₂O₃ single crystal growth apparatus, and Ga₂O₃ single crystal manufacturing step S100 will be respectively described. Fig. 5 is a schematic diagram illustrating a manufacturing apparatus used in the method for manufacturing a digallium trioxide single crystal according to the present embodiment. In the method for manufacturing a Ga₂O₃ single crystal according to the present embodiment (Ga₂O₃ single crystal manufacturing step S100), for example, a Ga₂O₃ single crystal growth apparatus illustrated in Fig. 5 is used.

### <Ga₂O₃ Single Crystal Growth Apparatus>

As illustrated in Fig. 5, the Ga₂O₃ single crystal growth apparatus includes crucible 2 described above, a crucible holding stage 8 for holding crucible 2, a lower shaft 9 for supporting both crucible 2 and crucible holding stage 8, and a heating device 1 for heating crucible 2. The Ga₂O₃ single crystal growth apparatus further includes a lid 3 for sealing crucible 2. Lid 3 has a function of preventing B₂O₃ from evaporating to the outside, due to heating, from a solution 52 in which Ga₂O₃ and the n-type dopant are dissolved in B₂O₃ (hereinafter, also referred to as "B₂O₃-Ga₂O₃ solution 52") held in crucible 2 in Ga₂O₃ single crystal growing step S140. The Ga₂O₃ single crystal growth apparatus has a nozzle for introducing the Ga₂O₃ polycrystal and the n-type dopant into crucible 2. The nozzle includes a first nozzle 41 and a second nozzle 42, and the tip of each nozzle is located inside crucible 2 by penetrating through lid 3 from the outside. First nozzle 41 functions as a supply path for supplying the Ga₂O₃ polycrystal into crucible 2 from the outside. Second nozzle 42 functions as a supply path for supplying the n-type dopant into crucible 2 from the outside.

In the method for manufacturing a Ga₂O₃ single crystal according to the present embodiment, although not shown in the drawings, a chamber capable of holding crucible 2, lid 3, first nozzle 41, second nozzle 42, crucible holding stage 8, lower shaft 9, and heating device 1 may be provided, in addition to the Ga₂O₃ single crystal growth apparatus described above, in some cases for the purpose of providing a nitrogen atmosphere as an atmosphere for performing Ga₂O₃ single crystal growing step S140. The dimension and material of the chamber are not especially limited as long as the chamber is large enough and made of a material that can hold the Ga₂O₃ single crystal growth apparatus and the like therein and provide a nitrogen atmosphere inside. Furthermore, when the chamber has a sidewall having good heat transmittance, the heating device of the Ga₂O₃ single crystal growth apparatus may be disposed outside the chamber.

### (Heating Device)

As illustrated in Fig. 5, in the Ga₂O₃ single crystal growth apparatus, heating device 1 is disposed to surround the outer periphery of crucible 2 for the purpose of heating crucible 2. Heating device 1 can, for example, employ a conventionally known electric heater (hereinafter also simply referred to as the "heater"). For example, two such heaters are disposed to surround the outer periphery of crucible 2. The output of each heater may be controlled independently. In particular, as illustrated in Fig. 5, each heater may be configured in multiple stages by being divided into several sections perpendicular to the axis of crucible 2. In such a case, the output of the heater is preferably independently controlled for each section configured in the multiple stages. In this manner, the temperature of the content in crucible 2 can be precisely adjusted along the axial direction of crucible 2. For example, by independently controlling the output of each section of the heater configured in the multiple stages, a growth rate of the Ga₂O₃ single crystal growing inside crucible 2 can be stabilized.

### (Crucible)

As illustrated in Fig. 5, crucible 2 is in a cylindrical shape in the Ga₂O₃ single crystal growth apparatus. Crucible 2 holds a seed crystal 51 made of a Ga₂O₃ single crystal at the bottom thereof. Besides, a block or powdered Ga₂O₃ polycrystal, an n-type dopant, and solid B₂O₃ are held above seed crystal 51. In other words, crucible 2 has a function of holding seed crystal 51, the G₂O₃ polycrystal, the n-type dopant, and the B₂O₃. In addition, crucible 2 has a function therein of growing a Ga₂O₃ single crystal on seed crystal 51 by precipitating a Ga₂O₃ single crystal from B₂O₃-Ga₂O₃ solution 52 as described below.

Various materials capable of withstanding the temperature of B₂O₃-Ga₂O₃ solution 52 can be used as crucible 2. For example, as the material of crucible 2, platinum, a platinum alloy containing rhodium or iridium, pBN or the like may be used. In particular, when Ga₂O₃ single crystal growing step S140 is carried out in an air atmosphere, crucible 2 is made of platinum. Thus, in the Ga₂O₃ single crystal obtained by the above-described manufacturing method, the concentrations of rhodium and iridium can be reduced to zero or extremely low concentrations (e.g., 0.1 mass ppm or less). Alternatively, when Ga₂O₃ single crystal growing step S140 is carried out in a nitrogen atmosphere, crucible 2 is made of pBN. In this case, the manufacturing cost of the Ga₂O₃ single crystal growth apparatus can be reduced. Also in the Ga₂O₃ single crystal obtained by this manufacturing method, the concentrations of rhodium and iridium can be reduced to zero or extremely low concentrations (e.g., 0.1 mass ppm or less). The inner diameter of crucible 2 can be, for example, 90 mm or more and 165 mm or less, although it depends on the diameter of the Ga₂O₃ single crystal to be manufactured.

Although not shown in the drawings, the Ga₂O₃ single crystal growth apparatus can be equipped with thermocouples capable of measuring the temperature of crucible 2 heated by heating device 1. A plurality of thermocouples may be disposed along the axial direction on the outside of crucible 2. For example, any of known temperature monitors can be used as the thermocouples.

### (Lid)

Lid 3 is not especially limited, and may be made of, for example, pBN, calcia (CaO)-stabilized zirconia, or the like in some cases. Lid 3 is disposed on crucible 2 for the purpose of preventing B₂O₃ from evaporating to the outside, due to heating, from B₂O₃-Ga₂O₃ solution 52 held in crucible 2 in Ga₂O₃ single crystal growing step S140. Lid 3 has holes through which the nozzles (first nozzle 41 and second nozzle 42) are inserted.

### (First Nozzle and Second Nozzle)

First nozzle 41 and second nozzle 42 are not especially limited, and may be made of, for example, pBN-coated carbon, sapphire or the like in some cases. First nozzle 41 and second nozzle 42 pass through lid 3 via the holes to have the tips inside crucible 2, thereby connecting the inside and outside of crucible 2. Thus, first nozzle 41 can function as a supply path for supplying Ga₂O₃ into crucible 2 from the outside. Second nozzle 42 can function as a supply path for supplying the n-type dopant into crucible 2 from the outside. By supplying the Ga₂O₃ polycrystal and the n-type dopant into B₂O₃-Ga₂O₃ solution 52 held in crucible 2 through first nozzle 41 and second nozzle 42, the concentrations of the Ga₂O₃ polycrystal and the n-type dopant in B₂O₃-Ga₂O₃ solution 52 can be always kept constant.

### (Crucible Holding Stage)

The Ga₂O₃ single crystal growth apparatus includes crucible holding stage 8 for holding crucible 2. Crucible holding stage 8 holds crucible 2 by contacting the bottom of crucible 2. Crucible holding stage 8 may have a cylindrical outer appearance in some cases. The material of crucible holding stage 8 is not especially limited, and for example, quartz, alumina, silicon carbide or the like can be used. The outer diameter of crucible holding stage 8 depends on the diameter of crucible 2 to be supported, and can be, for example, 75 mm or more and 200 mm or less.

### (Lower Shaft)

Lower shaft 9 can support crucible 2 and crucible holding stage 8 by supporting crucible holding stage 8 from below. Lower shaft 9 can be, for example, in a rod-like shape with a circular or rectangular cross-section when viewed horizontally. As the material of lower shaft 9, for example, molybdenum, carbon, silicon carbide or the like can be used. Now, the respective steps included in the method for manufacturing a Ga₂O₃ single crystal (Ga₂O₃ single crystal manufacturing step S100) will be described. Here, Ga₂O₃ single crystal manufacturing step S100 performed under an air atmosphere will be first described.

### <Ga₂O₃ Single Crystal Manufacturing Step S100>

### (First Step: Providing Step S110)

As illustrated in Fig. 4, providing step S110 is performed first in Ga₂O₃ single crystal manufacturing step S100. Providing step S110 is a step of providing a Ga₂O₃ single crystal growth apparatus that includes at least a cylindrical crucible and a heating device disposed to surround an outer periphery of the crucible. In providing step S110, seed crystal 51, block or powdered Ga₂O₃ polycrystal, an n-type dopant, and solid B₂O₃ are preferably respectively provided in addition to the Ga₂O₃ single crystal growth apparatus. Seed crystal 51 is made of a Ga₂O₃ single crystal as described above. The n-type dopant is provided preferably as, for example, tin oxide (SnO₂), silicon oxide (SiO₂), or the like. Seed crystal 51, block or powdered Ga₂O₃ polycrystal, an n-type dopant, and solid B₂O₃ may be provided by obtaining commercially available products. Crucible 2 included in the Ga₂O₃ single crystal growth apparatus is made of platinum.

### (Second Step: Raw Material Holding Step S120)

In Ga₂O₃ single crystal manufacturing step S100, raw material holding step S120 is subsequently performed. Raw material holding step S120 is a step of holding the seed crystal at a bottom of the crucible, and holding the Ga₂O₃ polycrystal, the n-type dopant, and the B₂O₃ above the seed crystal within the crucible. Raw material holding step S120 is performed for the purpose of holding, in crucible 2, various raw materials for performing crystal growth using the Ga₂O₃ single crystal growth apparatus. In raw material holding step S120, seed crystal 51 made of a Ga₂O₃ single crystal is first held at the bottom of crucible 2. Next, a plurality of block or powdered Ga₂O₃ polycrystals are held and stacked on seed crystal 51 held in crucible 2. Further, the n-type dopant and solid B₂O₃ are held therein. An amount of the n-type dopant to be held in crucible 2 is preferably predetermined so that a dopant concentration in a Ga₂O₃ single crystal to be grown can be appropriate. In this manner, an n-type Ga₂O₃ single crystal substrate is obtained from the Ga₂O₃ single crystal obtained in Ga₂O₃ single crystal manufacturing step S100. An amount of the n-type dopant to be held in crucible 2 is preferably adjusted such that, for example, the atomic concentration of Sn, Si, or Ge used as the dopant in the Ga₂O₃ single crystal substrate can be 2.0 × 10¹⁹ cm⁻³ or less (e.g., 1.0 × 10¹⁷ cm⁻³ or more and 2.0 × 10¹⁹ cm⁻³ or less).

### (Third Step: Raw Material Melting Step S130)

In Ga₂O₃ single crystal manufacturing step S100, raw material melting step S130 is subsequently performed. Raw material melting step S130 is a step of melting a portion of the seed crystal by heating the crucible with the heating device, obtaining a solution in which Ga₂O₃ derived from the portion of the seed crystal and the Ga₂O₃ polycrystal is dissolved at a first concentration, and the n-type dopant is dissolved at a second concentration in the B₂O₃, and contacting the solution with a remaining portion of the seed crystal. Raw material melting step S130 is performed for the purpose of, for performing the crystal growth with the Ga₂O₃ single crystal growth apparatus, melting a portion of seed crystal 51 by heating crucible 2 with heating device 1, and obtaining B₂O₃-Ga₂O₃ solution 52 in which Ga₂O₃ derived from the portion of seed crystal 51 and the Ga₂O₃ polycrystal is dissolved at the first concentration, and the n-type dopant is dissolved at the second concentration in the B₂O₃. In addition, the purpose is to contact B₂O₃-Ga₂O₃ solution 52 with a remaining portion of seed crystal 51. In this manner, in the next step of Ga₂O₃ single crystal growing step S140, a Ga₂O₃ single crystal can be grown on the remaining portion of seed crystal 51. Specifically, in raw material melting step S130, crucible 2 holding seed crystal 51, the Ga₂O₃ polycrystal, the n-type dopant, and the B₂O₃ is supported on crucible holding stage 8. Thereafter, a current is supplied to heating device 1 for heating crucible 2. Thus, the solid B₂O₃ melts to become liquid B₂O₃, and as the B₂O₃ is heated to a prescribed temperature (about 1000°C) or more, the Ga₂O₃ polycrystal gradually dissolves in the B₂O₃. The n-type dopant also dissolves in the B₂O₃. Subsequently, the portion of seed crystal 51 also melts to dissolve in the B₂O₃. In this manner, the remaining portion of seed crystal 51 contacts with B₂O₃-Ga₂O₃ solution 52.

Here, the first concentration, namely, the concentration of Ga₂O₃ in the B₂O₃ in B₂O₃-Ga₂O₃ solution 52, is preferably 20 to 40% by mass. The concentration of Ga₂O₃ that can dissolve in B₂O₃ depends on the temperature of the B₂O₃. Therefore, in raw material melting step S130, B₂O₃-Ga₂O₃ solution 52 is preferably heated to 1200 to 1500°C. In this case, the second concentration, namely, the concentration of the n-type dopant in the B₂O₃ in B₂O₃-Ga₂O₃ solution 52, may be a concentration applicable to a conventionally known method for manufacturing a Ga₂O₃ single crystal, and is preferably, for example, 2 to 300 mass ppm. The first concentration and the second concentration can be measured in the same manner as in measurement of a Ga₂O₃ concentration and an n-type dopant concentration in an analysis step described below.

### (Fourth Step: Ga₂O₃ Single Crystal Growing Step S140)

In Ga₂O₃ single crystal manufacturing step S100, Ga₂O₃ single crystal growing step S140 is subsequently performed. Ga₂O₃ single crystal growing step S140 is a step of growing a crystal from the solution on the remaining portion of the seed crystal to obtain a Ga₂O₃ single crystal. In Ga₂O₃ single crystal growing step S140, for example, by gradually lowering crucible 2 along the axis (toward the bottom of crucible 2) relative to heating device 1, a temperature gradient, in which the temperature is low on the side of seed crystal 51, and high on the side of B₂O₃-Ga₂O₃ solution 52, can be formed within crucible 2. As a result, crystal growth can be continuously performed by precipitating a Ga₂O₃ single crystal through a solubility difference between the B₂O₃ and the Ga₂O₃ at a portion in contact with seed crystal 51 in B₂O₃-Ga₂O₃ solution 52. In this case, in order to obtain a Ga₂O₃ single crystal in the form of a single crystal ingot with a continuous crystal lattice, a speed of lowering crucible 2 along the axis is preferably, for example, 1 to 3 mm/hour. A temperature at the portion in contact with seed crystal 51 in B₂O₃-Ga₂O₃ solution 52 (hereinafter, also referred to as the "seed crystal portion") is preferably 1150 to 1430 °C, and more preferably 1200 to 1388°C.

In Ga₂O₃ single crystal growing step S140, a Ga₂O₃ single crystal is precipitated from B₂O₃-Ga₂O₃ solution 52 through a solubility difference between the B₂O₃ and the Ga₂O₃, and therefore, the Ga₂O₃ concentration and the n-type dopant concentration in B₂O₃-Ga₂O₃ solution 52 reduce as the step proceeds. Accordingly, Ga₂O₃ single crystal growing step S140 preferably includes analyzing the concentrations of Ga₂O₃ derived from the portion of the seed crystal and the Ga₂O₃ polycrystal, and the n-type dopant in the solution by sampling, through the nozzle, the solution within the crucible sealed by the lid (hereinafter, also referred to as the "analysis step"). Besides, Ga₂O₃ single crystal growing step S140 preferably includes adding, in accordance with a result of the analysis about the Ga₂O₃ concentration, the Ga₂O₃ polycrystal to the solution in the crucible through the nozzle such that the Ga₂O₃ concentration can be within plus or minus 5% of the first concentration (hereinafter, also referred to as the "Ga₂O₃ concentration adjusting step"). Ga₂O₃ single crystal growing step S140 preferably includes adding, in accordance with a result of the analysis about the n-type dopant concentration, the n-type dopant to the solution in the crucible through the nozzle such that the n-type dopant concentration can be within plus or minus 5% of the second concentration (hereinafter, also referred to as the "n-type dopant concentration adjusting step"). Since the manufacturing method includes these steps, the Ga₂O₃ and n-type dopant concentrations in B₂O₃-Ga₂O₃ solution 52 can be consistently stabilized from the beginning to the end of the Ga₂O₃ single crystal growing step S140. As a result, a Ga₂O₃ single crystal in which the B concentration is uniform throughout the respective portions of the Ga₂O₃ single crystal can be obtained, and therefore, a Ga₂O₃ single crystal to be used for manufacturing a Ga₂O₃ single crystal substrate capable of suppressing occurrence of cracks can be obtained with a high yield.

Specifically, in the analysis step, B₂O₃-Ga₂O₃ solution 52 within crucible 2 sealed with lid 3 is sampled, during Ga₂O₃ single crystal growing step S140, at predetermined time intervals (e.g., every 2 hours) through first nozzle 41 or second nozzle 42 by an appropriate method. For the sampling, about 0.5 g of B₂O₃-Ga₂O₃ solution 52 is collected from crucible 2 through first nozzle 41 or second nozzle 42, for example, using a pipe made of the same material as the nozzle. Besides, after subjecting this about 0.5 g of B₂O₃-Ga₂O₃ solution 52 to acid dissolution by a known method, the concentrations of Ga₂O₃ and the n-type dopant in B₂O₃-Ga₂O₃ solution 52 can be respectively analyzed by inductively coupled plasma (ICP) atomic emission spectrometry or ICP-mass spectrometry.

In the Ga₂O₃ concentration adjusting step, in accordance with a result of the analysis about the Ga₂O₃ concentration obtained at predetermined time intervals in the analysis step, the Ga₂O₃ polycrystal is added to B₂O₃-Ga₂O₃ solution 52 in crucible 2 through first nozzle 41 such that the Ga₂O₃ concentration can be within plus or minus 5% of the first concentration. If the Ga₂O₃ concentration is found to be within plus or minus 5% of the first concentration as the analysis result in the Ga₂O₃ concentration adjusting step, the Ga₂O₃ polycrystal is not added.

Besides, in Ga₂O₃ single crystal growing step S140, the n-type dopant concentration in B₂O₃-Ga₂O₃ solution 52 also reduces in accordance with the precipitation of the Ga₂O₃ single crystal. Therefore, in the n-type dopant concentration adjusting step, in accordance with a result of the analysis about the Ga₂O₃ concentration obtained at predetermined time intervals in the analysis step, the n-type dopant is added to B₂O₃-Ga₂O₃ solution 52 in crucible 2 through second nozzle 42 such that the n-type dopant concentration can be within plus or minus 5% of the second concentration. If the n-type dopant concentration is found to be within plus or minus 5% of the second concentration as the analysis result in the n-type dopant concentration adjusting step, the n-type dopant is not added.

In Ga₂O₃ single crystal growing step S140, in accordance with the precipitation of the Ga₂O₃ single crystal described above, the B₂O₃ in B₂O₃-Ga₂O₃ solution 52 may be incorporated into the Ga₂O₃ single crystal and, at the same time, may be lost through sublimation in some cases. Accordingly, if the B₂O₃ concentration in B₂O₃-Ga₂O₃ solution 52 excessively reduces, the B₂O₃ concentration can be also adjusted by adding B₂O₃ through first nozzle 41.

In Ga₂O₃ single crystal growing step S140, when crucible 2 is lowered along the axis relative to heating device 1 at the above-described speed, a Ga₂O₃ single crystal continuously precipitates in crucible 2 from B₂O₃-Ga₂O₃ solution 52, the thickness as an ingot increases, and simultaneously, the interface between the Ga₂O₃ single crystal and B₂O₃-Ga₂O₃ solution 52 rises toward the side of lid 3. The crystal growth of the Ga₂O₃ single crystal continues until the thickness of the ingot of the Ga₂O₃ single crystal reaches a desired thickness. In this manner, a Ga₂O₃ single crystal can be obtained. A boron concentration in the Ga₂O₃ single crystal is 4 mass ppm or more and 200 mass ppm or less by GDMS. The boron concentration in the Ga₂O₃ single crystal is preferably 5 mass ppm or more and 100 mass ppm or less by GDMS. GDMS for the Ga₂O₃ single crystal can be performed in the same manner as GDMS for the Ga₂O₃ single crystal substrate described above.

Herein, in the method for manufacturing a Ga₂O₃ single crystal, a series of steps described above can be performed also in a nitrogen atmosphere. In such an embodiment, crucible 2 included in the Ga₂O₃ single crystal growth apparatus is made of pBN. Besides, for performing the above-described series of steps in a nitrogen atmosphere, the Ga₂O₃ single crystal growth apparatus is held in a chamber filled with nitrogen. Also by the method for manufacturing a Ga₂O₃ single crystal having these characteristics, a Ga₂O₃ single crystal to be used for manufacturing a Ga₂O₃ single crystal substrate capable of suppressing occurrence of cracks can be obtained.

### [Method for Manufacturing Digallium Trioxide Single Crystal Substrate]

### <Ga₂O₃ Single Crystal Substrate Manufacturing Step S200>

The method for manufacturing a Ga₂O₃ single crystal substrate of the present embodiment includes a Ga₂O₃ single crystal substrate manufacturing step of processing the Ga₂O₃ single crystal obtained by the method for manufacturing a Ga₂O₃ single crystal described above to obtain a Ga₂O₃ single crystal substrate having a circular main surface. As illustrated in Fig. 4, the method for manufacturing a Ga₂O₃ single crystal substrate includes Ga₂O₃ single crystal manufacturing step S100, and Ga₂O₃ single crystal substrate manufacturing step S200. Ga₂O₃ single crystal substrate manufacturing step S200 is performed for the purpose of processing the Ga₂O₃ single crystal obtained through Ga₂O₃ single crystal manufacturing step S100 to obtain a Ga₂O₃ single crystal substrate. Ga₂O₃ single crystal substrate manufacturing step S200 includes a cutting step, an outer periphery grinding step, and a polishing step as described below, and by executing these steps in the stated order, a Ga₂O₃ single crystal substrate can be obtained.

The cutting step is a step in which the ingot of the Ga₂O₃ single crystal, taken out of crucible 2, is sliced into wafers of a predetermined thickness to obtain a Ga₂O₃ single crystal substrate from the ingot. The outer periphery grinding step is a step of grinding the outer periphery of the wafer to obtain a wafer having a main surface including a central part and an outer peripheral part surrounding the periphery of the central part. The outer periphery grinding step is specifically a chamfering step. Therefore, by this outer periphery grinding step, a main surface having a chamfered region as the outer peripheral part can be obtained. For the cutting step and the outer periphery grinding step, any conventionally known cutting methods and outer periphery grinding methods can be employed. The polishing step is a step of mirror-finishing the central part of the main surface. In the polishing step, any conventionally known polishing method can be employed. Through the polishing step, the central part can achieve a surface roughness Ra, as defined by, for example, JIS B 0681-2: 2018, of 20 nm or less.

### [Advantageous Effects]

A Ga₂O₃ single crystal substrate according to the present embodiment is manufactured by executing the above-described steps. In the method for manufacturing a Ga₂O₃ single crystal described above, particularly in Ga₂O₃ single crystal growing step S140, a Ga₂O₃ single crystal in which a small amount of B₂O₃ is incorporated in the precipitated Ga₂O₃ single crystal can be grown. Thus, a Ga₂O₃ single crystal substrate having appropriate strength capable of suppressing occurrence of cracks can be obtained from the Ga₂O₃ single crystal containing B.

### Examples

Now, the present disclosure will be described in more detail by way of examples, and the present disclosure is not limited by these examples. In the examples, a Ga₂O₃ single crystal manufacturing apparatus as illustrated in Fig. 5 was used to manufacture a Ga₂O₃ single crystal substrate in accordance with the flowchart illustrated in Fig. 4. In the following description, samples 11 to 19 correspond to Examples, and samples a to c correspond to Comparative Examples.

### [Manufacture of Ga₂O₃ Single Crystal Substrate]

### <Sample a>

According to a method disclosed in PTL 1, a Ga₂O₃ single crystal was obtained by employing the Vertical Bridgman (VB) method. In obtaining the Ga₂O₃ single crystal, an appropriate amount of tin oxide (SnO₂) was added as an n-type dopant. A Ga₂O₃ single crystal substrate of Sample a was obtained by performing the cutting step, the outer periphery grinding step, and the polishing step described above on the Ga₂O₃ single crystal in the stated order. The Ga₂O₃ single crystal substrate of Sample a had a diameter of 100 mm, and a thickness of 650 µm.

### <Sample b>

### (Providing Step S110 in Ga₂O₃ Single Crystal Manufacturing Step S100)

The Ga₂O₃ single crystal growth apparatus, seed crystal 51 made of a Ga₂O₃ single crystal, a block Ga₂O₃ polycrystal, SnO₂ as the n-type dopant, and solid B₂O₃ were provided by conventionally known methods, or provided by obtaining commercially available products. As crucible 2 included in the Ga₂O₃ single crystal growth apparatus, a crucible of platinum having an inner diameter of 105 mm was used.

### (Raw Material Holding Step S120 in Ga₂O₃ Single Crystal Manufacturing Step S100)

Next, by a conventionally known method, seed crystal 51 was held at a bottom of crucible 2, and the block Ga₂O₃ polycrystal, SnO₂, and solid B₂O₃ were held above seed crystal 51 in the stated order. Specifically, a plurality of block Ga₂O₃ polycrystals were held and stacked. Subsequently, SnO₂ was added on the Ga₂O₃ polycrystals, and the solid B₂O₃ was disposed thereon. An amount of the SnO₂ to be added was set so that the atomic concentration of Sn in a Ga₂O₃ single crystal substrate could be 3.0 × 10¹⁸ cm⁻³.

### (Raw Material Melting Step S130 in Ga₂O₃ Single Crystal Manufacturing Step S100)

Next, crucible 2 holding seed crystal 51, the block Ga₂O₃ polycrystal, SnO₂, and solid B₂O₃ therein was supported on crucible holding stage 8. Thereafter, a current was supplied to heating device 1 for heating crucible 2, to melt the solid B₂O₃ into liquid B₂O₃, and melt the Ga₂O₃ polycrystal and a portion of seed crystal 51, and SnO₂ in the B₂O₃, and thus, B₂O₃-Ga₂O₃ solution 52 was prepared. The first concentration, namely, the concentration of Ga₂O₃ in B₂O₃ in the B₂O₃-Ga₂O₃ solution 52, was set to 20 mass%. The second concentration, namely, the concentration of SnO₂ in the B₂O₃, was set to 100 mass ppm. Subsequently, the remaining portion of seed crystal 51 and the B₂O₃-Ga₂O₃ solution 52 were contacted with each other at the interface thereof.

### (Ga₂O₃ Single Crystal Growing Step S140 in Ga₂O₃ Single Crystal Manufacturing Step S100)

Next, by gradually lowering crucible 2 along the axis (toward the bottom) relative to heating device 1, a temperature gradient, in which the temperature was low on the side of seed crystal 51 in the crucible 2, and high on the side of B₂O₃-Ga₂O₃ solution 52, was formed. In this manner, crystal growth was continuously performed by precipitating a Ga₂O₃ single crystal through a solubility difference between the B₂O₃ and the Ga₂O₃ at a seed crystal portion, that is, a portion in contact with seed crystal 51 in B₂O₃-Ga₂O₃ solution 52. Besides, this operation was continued until the thickness of the Ga₂O₃ single crystal reached 30 mm. The temperature of the seed crystal portion was set to 1100°C. The speed of lowering crucible 2 along the axis was set to 2 mm/hour. In this manner, an ingot of the Ga₂O₃ single crystal was obtained.

In Ga₂O₃ single crystal growing step S140, the analysis step, the Ga₂O₃ concentration adjusting step, and the n-type dopant concentration adjusting step described above were performed. Thus, the concentrations of the Ga₂O₃ and the n-type dopant in B₂O₃-Ga₂O₃ solution 52 were controlled to be within plus or minus 5% from the beginning to the end of Ga₂O₃ single crystal growing step S140.

### (Ga₂O₃ Single Crystal Substrate Manufacturing Step S200)

Finally, the ingot of the Ga₂O₃ single crystal obtained in Ga₂O₃ single crystal growing step S140 was processed through the cutting step, the outer periphery grinding step, and the polishing step to obtain a Ga₂O₃ single crystal substrate. First, in the cutting step, the ingot was sliced into a wafer with a thickness of 700 µm by a conventionally known method. In the outer periphery grinding step, the wafer was ground to be chamfered on the outer periphery by a conventionally known method, and thus, a wafer having a main surface including a central part and an outer peripheral part surrounding the periphery of the central part was obtained. In the polishing step, the central part was polished by a conventionally known polishing method to achieve, in the central part, a surface roughness Ra, as defined by, for example, JIS B 0681-2: 2018, of 0.2 nm.

In this manner, a Ga₂O₃ single crystal substrate of Sample b was manufactured. The Ga₂O₃ single crystal substrate of Sample b had a diameter of 100 mm, and a thickness of 650 µm.

### <Sample c>

A Ga₂O₃ single crystal substrate of Sample c was manufactured in the same manner as Sample b except that the first concentration in B₂O₃-Ga₂O₃ solution 52 prepared in raw material melting step S130 was changed to 25% by mass, and that the temperature of the seed crystal portion in Ga₂O₃ single crystal growing step S140 was changed to 1500°C. The Ga₂O₃ single crystal substrate of Sample c had a diameter of 100 mm, and a thickness of 650 µm.

### <Sample 11>

A Ga₂O₃ single crystal substrate of Sample 11 was manufactured in the same manner as Sample b except that the first concentration in B₂O₃-Ga₂O₃ solution 52 prepared in raw material melting step S130 was changed to 20% by mass, and that the temperature of the seed crystal portion in Ga₂O₃ single crystal growing step S140 was changed to 1200°C. The Ga₂O₃ single crystal substrate of Sample 11 had a diameter of 100 mm, and a thickness of 650 µm.

### <Sample 12>

A Ga₂O₃ single crystal substrate of Sample 12 was manufactured in the same manner as Sample 11 except that the temperature of the seed crystal portion in Ga₂O₃ single crystal growing step S140 was changed to 1273°C. The Ga₂O₃ single crystal substrate of Sample 12 had a diameter of 100 mm, and a thickness of 650 µm.

### <Sample 13>

A Ga₂O₃ single crystal substrate of Sample 13 was manufactured in the same manner as Sample 11 except that the first concentration in B₂O₃-Ga₂O₃ solution 52 prepared in raw material melting step S130 was changed to 25% by mass, and that the temperature of the seed crystal portion in Ga₂O₃ single crystal growing step S140 was changed to 1323°C. The Ga₂O₃ single crystal substrate of Sample 13 had a diameter of 100 mm, and a thickness of 650 µm .

### <Sample 14>

A Ga₂O₃ single crystal substrate of Sample 14 was manufactured in the same manner as Sample 13 except that a chamber for holding the single crystal growth apparatus therein and crucible 2 made of pBN were provided in the providing step S110, that raw material melting step S130 and Ga₂O₃ single crystal growing step S140 were performed in a nitrogen atmosphere, and that the temperature of the seed crystal portion in Ga₂O₃ single crystal growing step S140 was changed to 1348°C. The Ga₂O₃ single crystal substrate of Sample 14 had a diameter of 100 mm, and a thickness of 650 µm.

### <Sample 15>

A Ga₂O₃ single crystal substrate of Sample 15 was manufactured in the same manner as Sample 13 except that the temperature of the seed crystal portion in Ga₂O₃ single crystal growing step S140 was changed to 1368°C. The Ga₂O₃ single crystal substrate of Sample 15 had a diameter of 100 mm, and a thickness of 650 µm.

### <Sample 16>

A Ga₂O₃ single crystal substrate of Sample 16 was manufactured in the same manner as Sample 13 except that the temperature of the seed crystal portion in Ga₂O₃ single crystal growing step S140 was changed to 1388°C. The Ga₂O₃ single crystal substrate of Sample 16 had a diameter of 100 mm, and a thickness of 650 µm.

### <Sample 17>

A Ga₂O₃ single crystal substrate of Sample 17 was manufactured in the same manner as Sample 13 except that crucible 2 having an inner diameter of 160 mm was provided in providing step S110, and that the temperature of the seed crystal portion in Ga₂O₃ single crystal growing step S140 was changed to 1273°C. The Ga₂O₃ single crystal substrate of Sample 17 had a diameter of 150 mm, and a thickness of 680 µm .

### <Sample 18>

A Ga₂O₃ single crystal substrate of Sample 18 was manufactured in the same manner as Sample 17 except that the temperature of the seed crystal portion in Ga₂O₃ single crystal growing step S140 was changed to 1323°C. The Ga₂O₃ single crystal substrate of Sample 18 had a diameter of 150 mm, and a thickness of 680 µm.

### <Sample 19>

A Ga₂O₃ single crystal substrate of Sample 19 was manufactured in the same manner as Sample 17 except that a chamber for holding the single crystal growth apparatus therein and crucible 2 made of pBN were provided in the providing step S110, that raw material melting step S130 and Ga₂O₃ single crystal growing step S140 were performed in a nitrogen atmosphere, and that the temperature of the seed crystal portion in Ga₂O₃ single crystal growing step S140 was changed to 1388°C. The Ga₂O₃ single crystal substrate of Sample 19 had a diameter of 150 mm, and a thickness of 680 µm.

### [Composition Analysis by GDMS]

A composition analysis method by GDMS described above was performed on the Ga₂O₃ single crystal substrates of Samples a to c and Samples 11 to 19 to measure the B concentration in the Ga₂O₃ single crystal substrates. The results are shown in Table 1. The unit for the concentration of each element shown in Table 1 is mass ppm. Furthermore, "< 0.3" in Table 1 indicates that the concentration was less than 0.3 mass ppm.

### [Measurement of Nanoindentation Hardness]

The measurement method described above was performed on the Ga₂O₃ single crystal substrates of Samples a to c and Samples 11 to 19 to measure nanoindentation hardnesses respectively at prescribed 5 positions on the main surfaces. The measurement apparatus and conditions employed for performing the measurement method were as follows.

Apparatus used: Nanoindenter (product name: "Bruker Hysitron TI 980 TriboIndenter", manufactured by Bruker Japan K.K.)
Indenter used: Berkovich indenter
Maximum load: 10 mN
Measurement atmosphere: air
Measurement temperature: room temperature (25°C)

Angle of intersection between at least one side of an indenter ridgeline and a direction of the [100] orientation of the Ga₂O₃ single crystal projected onto the main surface: 0 to 10°

An average of 3 measurement values obtained by the measurement performed at the same position on the same substrate three times was defined as the nanoindentation hardness, and this average was obtained at each of the 5 prescribed positions on the main surface. Furthermore, an average value (unit: GPa) was obtained from the 5 nanoindentation hardness values in total obtained at the 5 positions. A difference between the maximum and minimum values of the nanoindentation hardness (shown as "Max-Min Difference" in Table 1) at each of the 5 prescribed positions on the main surface was also obtained. The 5 prescribed positions refer to the following positions on the main surface. Specifically, when a length from the center of the main surface to the boundary between the central part and the outer peripheral part is defined as r, two mutually orthogonal axes on the main surface passing through the center correspond respectively to the X axis and Y axis, and the Y axis corresponds to the b axis of the Ga₂O₃ single crystal, coordinates (X, Y) of the 9 positions defined by the X axis and Y axis are (0, 0), (r-5, 0), (0, r-5), (-(r-5), 0), and (0, -(r-5)). The unit for the r, and for X and Y in the aforementioned coordinates (X, Y), is mm. The r of Samples a, b, and c, and Samples 11 to 16 was 48 mm. The r of Samples 17 to 19 was 74 mm. The results are shown in Table 1.

### [Fracture Load Test]

In the Ga₂O₃ single crystal substrate of each of Samples a to c, and Samples 11 to 19, a load at which the substrate fractured was checked by applying a load to the center of the main surface using a force gauge. The results are shown in Table 1. In the evaluation, a higher measured load indicates greater resistance to cracking. The force gauge and attachment used for performing the fracture load test were as follows.
Force gauge: "PS-200N (model)", manufactured by IMADA Co., Ltd., maximum load: 200 N
Attachment: conical (S-3)

### [Specific Resistance, Carrier Concentration, and Electron Mobility]

In the Ga₂O₃ single crystal substrate of each of Samples a to c and Samples 11 to 19, a Hall measurement sample was prepared using the central part of the substrate, and by performing the aforementioned measurement method on the Hall measurement sample, the specific resistance, carrier concentration, and electron mobility of each sample were obtained. The results are shown in Table 2.

### [Table 1]

**Table. 1**

| | Diameter (mm) | Ga₂O₃ concentration (mass%) | Seed crystal temperature (°C) | B concentration (mass ppm) | Nanoindentation hardness | | Fracture load (N) |
|---|---|---|---|---|---|---|---|
| | | | | | Average (GPa) | Max-min difference (GPa) | |
| Sample a | 100 | - | - | <0.3 | 14.0 | 3.0 | 80 |
| Sample b | 100 | 20 | 1100 | 1 | 14.1 | 3.0 | 80 |
| Sample c | 100 | 25 | 1500 | 1000 | 25.0 | 4.0 | 82 |
| Sample 11 | 100 | 20 | 1200 | 4 | 14.9 | 2.5 | 96 |
| Sample 12 | 100 | 20 | 1273 | 5 | 15.0 | 2.4 | 102 |
| Sample 13 | 100 | 25 | 1323 | 50 | 17.1 | 1.0 | 115 |
| Sample 14 | 100 | 25 | 1348 | 100 | 18.4 | 1.5 | 120 |
| Sample 15 | 100 | 25 | 1368 | 150 | 19.4 | 2.0 | 110 |
| Sample 16 | 100 | 25 | 1388 | 200 | 20.2 | 2.5 | 100 |
| Sample 17 | 150 | 25 | 1273 | 4 | 15.0 | 2.5 | 90 |
| Sample 18 | 150 | 25 | 1323 | 5 | 17.4 | 1.0 | 120 |
| Sample 19 | 150 | 25 | 1388 | 200 | 21.0 | 2.5 | 95 |

### [Table 2]

**Table. 2**

| | Specific resistance (Ω·cm) | Carrier concentration (cm⁻³) | Electron mobility (cm²/V·s) |
|---|---|---|---|
| Sample a | 0.024 | 3.8×10¹⁸ | 69 |
| Sample b | 0.024 | 3.9×10¹⁸ | 67 |
| Sample c | 0.014 | 5.0×10¹⁸ | 89 |
| Sample 11 | 0.028 | 3.6×10¹⁸ | 62 |
| Sample 12 | 0.028 | 3.6×10¹⁸ | 62 |
| Sample 13 | 0.027 | 3.6×10¹⁸ | 64 |
| Sample 14 | 0.029 | 3.6×10¹⁸ | 60 |
| Sample 15 | 0.030 | 3.6×10¹⁸ | 58 |
| Sample 16 | 0.029 | 3.6×10¹⁸ | 60 |
| Sample 17 | 0.010 | 5.0×10¹⁷ | 1250 |
| Sample 18 | 0.010 | 5.0×10¹⁷ | 1250 |
| Sample 19 | 0.012 | 4.8×10¹⁷ | 1085 |

### [Discussion]

Referring to Tables 1 and 2, the B concentration obtained by GDMS was 4 mass ppm or more and 200 mass ppm or less in all of the Ga₂O₃ single crystal substrates of Samples 11 to 19. In this case, the nanoindentation hardness showed average values of 14.8 GPa or more and 22.0 GPa or less, and the fracture load was 90 N or more in all the samples. On the contrary, the B concentration obtained by GDMS was less than 4 mass ppm or more than 200 mass ppm in all of the Ga₂O₃ single crystal substrates of Samples a to c. In this case, the nanoindentation hardness showed average values less than 14.8 GPa or more than 22.0 GPa, and the fracture load was less than 90 N. Accordingly, it was suggested that the occurrence of cracks is suppressed in the Ga₂O₃ single crystal substrates of Samples 11 to 19.

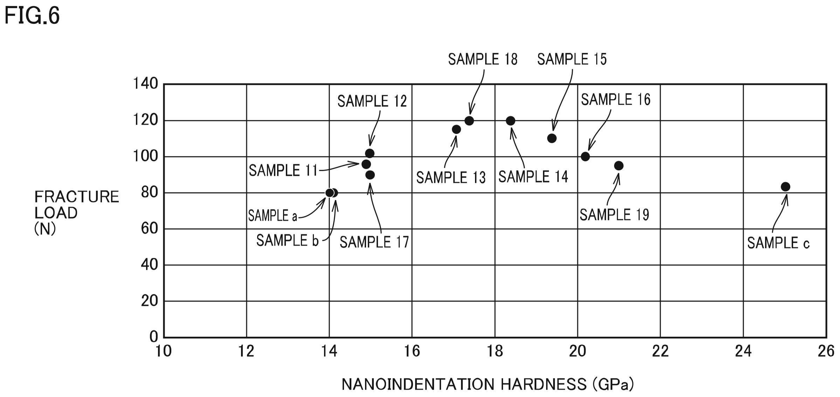

Fig. 6 is a graph illustrating a relationship between the nanoindentation hardness and the fracture load in the digallium trioxide single crystal substrates manufactured in Examples. In particular, it is understood, referring to Fig. 6, that a Ga₂O₃ single crystal substrate exhibits a fracture load of 90 N or more when having nanoindentation hardness of 14.8 GPa or more and 22.0 GPa or less.

Although the embodiments and examples of this disclosure have been described so far, it is also initially intended that the configurations of the above-mentioned embodiments and examples may be appropriately combined.

The embodiments and examples disclosed herein are to be considered in all respects as illustrative and not restrictive. The scope of the present invention is indicated by the appended claims rather than by the foregoing embodiments and examples, and all changes that come within the meaning and range of equivalency of the claims are therefore intended to be embraced therein.

### REFERENCE SIGNS LIST

100 Digallium trioxide single crystal substrate (Ga₂O₃ single crystal substrate); O Center; r Length from center of main surface to boundary between central part and outer peripheral part; 10 Main surface; 11 Central part; 12 Outer peripheral part; 13 Boundary; 21 Electrode; 1 Heating device; 2 Crucible; 3 Lid; 41 First nozzle; 42 Second nozzle; 51 Seed crystal; 52 B₂O₃-Ga₂O₃ solution; 8 Crucible holding stage; 9 Lower shaft; O Center; r Length from center of main surface to boundary between central part and outer peripheral part; S100 Ga₂O₃ single crystal manufacturing step; S110 Providing step; S120 Raw material holding step; S130 Raw material melting step; S140 Ga₂O₃ single crystal growing step; S200 Ga₂O₃ single crystal substrate manufacturing step.

## Claims

1. A digallium trioxide single crystal substrate having a circular main surface, wherein
the digallium trioxide single crystal substrate has a diameter of 100 mm or more,
the digallium trioxide single crystal substrate has a thickness of 600 µm or more, and
the digallium trioxide single crystal substrate comprises boron, wherein
a concentration of the boron is 4 mass ppm or more and 200 mass ppm or less by glow discharge mass spectrometry.

2. The digallium trioxide single crystal substrate according to claim 1, wherein the concentration of the boron is 5 mass ppm or more and 100 mass ppm or less by glow discharge mass spectrometry.

3. The digallium trioxide single crystal substrate according to claim 1 or 2, wherein
the main surface is a (001) plane of a digallium trioxide single crystal,
the main surface has a central part including a center thereof, and an outer peripheral part surrounding the central part,
the outer peripheral part is a chamfered region,
nanoindentation hardness, as measured at 5 positions on the main surface according to a nanoindentation method using a Berkovich indenter under a condition where a maximum load is 10 mN, and a load is applied in such a manner that an angle of intersection between one side of indentation and a direction of a [100] orientation of the digallium trioxide single crystal projected onto the main surface is 0° or more and 10° or less, is 14.8 GPa or more and 22.0 GPa or less at all the positions, and
when a length from the center of the main surface to a boundary between the central part and the outer peripheral part is defined as r, two mutually orthogonal axes on the main surface passing through the center correspond to an X axis and a Y axis, and the Y axis corresponds to a b axis of the digallium trioxide single crystal, coordinates (X, Y) of the 5 positions defined by the X axis and the Y axis are (0, 0), (r-5, 0), (0, r-5), (-(r-5), 0), and (0, -(r-5)), and a unit for the r, and the X and the Y in the coordinates (X, Y) is mm.

4. The digallium trioxide single crystal substrate according to any one of claims 1 to 3, wherein
the digallium trioxide single crystal substrate comprises either or both of rhodium and iridium, wherein
concentrations of the rhodium and the iridium are both 0.1 mass ppm or less by glow discharge mass spectrometry.

5. The digallium trioxide single crystal substrate according to any one of claims 1 to 4, wherein
specific resistance of the digallium trioxide single crystal substrate, as measured at 25°C through Hall measurement by Van der Pauw method, is 1.0 × 10⁻³ Ω·cm or more and 2.0 Ω·cm or less,
a carrier concentration in the digallium trioxide single crystal substrate, as measured at 25°C through Hall measurement by Van der Pauw method, is 4.0 × 10¹⁷ cm⁻³ or more and 1.4 × 10¹⁹ cm⁻³ or less, and
electron mobility of the digallium trioxide single crystal substrate, as measured at 25°C through Hall measurement by Van der Pauw method, is 0.2 cm²/V·s or more and 15000 cm²/V·s or less.

6. A method for manufacturing a digallium trioxide single crystal, performed under an air atmosphere, the method comprising:
providing a single crystal growth apparatus that includes at least a cylindrical crucible and a heating device disposed to surround an outer periphery of the crucible;
holding a seed crystal made of the digallium trioxide single crystal at a bottom of the crucible, and holding a block or powdered digallium trioxide polycrystal, an n-type dopant, and boron oxide above the seed crystal within the crucible;
melting a portion of the seed crystal by heating the crucible with the heating device, obtaining a solution in which digallium trioxide derived from the portion of the seed crystal and the digallium trioxide polycrystal is dissolved at a first concentration, and the n-type dopant is dissolved at a second concentration in the boron oxide, and contacting the solution with a remaining portion of the seed crystal; and
growing a crystal from the solution on the remaining portion of the seed crystal to obtain a digallium trioxide single crystal,
wherein the crucible is made of platinum, and
a boron concentration in the digallium trioxide single crystal is 4 mass ppm or more and 200 mass ppm or less by glow discharge mass spectrometry.

7. A method for manufacturing a digallium trioxide single crystal, performed under a nitrogen atmosphere, the method comprising:
providing a single crystal growth apparatus that includes at least a cylindrical crucible and a heating device disposed to surround an outer periphery of the crucible;
holding a seed crystal made of the digallium trioxide single crystal at a bottom of the crucible, and holding a block or powdered digallium trioxide polycrystal, an n-type dopant, and boron oxide above the seed crystal within the crucible;
melting a portion of the seed crystal by heating the crucible with the heating device, obtaining a solution in which digallium trioxide derived from the portion of the seed crystal and the digallium trioxide polycrystal is dissolved at a first concentration, and the n-type dopant is dissolved at a second concentration in the boron oxide, and contacting the solution with a remaining portion of the seed crystal; and
growing a crystal from the solution on the remaining portion of the seed crystal to obtain a digallium trioxide single crystal,
wherein the crucible is made of pyrolytic boron nitride, and
a boron concentration in the digallium trioxide single crystal is 4 mass ppm or more and 200 mass ppm or less by glow discharge mass spectrometry.

8. The method for manufacturing a digallium trioxide single crystal according to claim 6 or 7, wherein
the single crystal growth apparatus has a nozzle for introducing the digallium trioxide polycrystal and the n-type dopant into the crucible, and a lid for sealing the crucible,
the lid has a hole through which the nozzle is inserted,
the growing to obtain a digallium trioxide single crystal includes:
sampling, through the nozzle, the solution within the crucible, which is sealed by the lid, to analyze concentrations, in the solution, of the digallium trioxide derived from the portion of the seed crystal and the digallium trioxide polycrystal, and the n-type dopant;
introducing, according to a result of analysis about the concentration of the digallium trioxide, the digallium trioxide polycrystal into the solution within the crucible through the nozzle, such that a concentration of the digallium trioxide is within plus or minus 5% of the first concentration; and
introducing, according to a result of analysis about the concentration of the n-type dopant, the n-type dopant into the solution within the crucible through the nozzle, such that a concentration of the n-type dopant is within plus or minus 5% of the second concentration.

9. A method for manufacturing a digallium trioxide single crystal substrate comprising: processing the digallium trioxide single crystal obtained by the method for manufacturing a digallium trioxide single crystal according to any one of claims 6 to 8 to obtain a digallium trioxide single crystal substrate having a circular main surface.

10. The digallium trioxide single crystal substrate according to claim 2, wherein
the main surface is a (001) plane of a digallium trioxide single crystal,
the main surface has a central part including a center thereof, and an outer peripheral part surrounding the central part,
the outer peripheral part is a chamfered region,
nanoindentation hardness, as measured at 5 positions on the main surface according to a nanoindentation method using a Berkovich indenter under a condition where a maximum load is 10 mN, and a load is applied in such a manner that an angle of intersection between one side of indentation and a direction of a [100] orientation of the digallium trioxide single crystal projected onto the main surface is 0° or more and 10° or less, is 14.8 GPa or more and 22.0 PGa or less at all the positions,
when a length from the center of the main surface to a boundary between the central part and the outer peripheral part is defined as r, two mutually orthogonal axes on the main surface passing through the center correspond respectively to an X axis and a Y axis, and the Y axis corresponds to a b axis of the digallium trioxide single crystal, coordinates (X, Y) of the 5 positions defined by the X axis and the Y axis are (0, 0), (r-5, 0), (0, r-5), (-(r-5), 0), and (0, -(r-5)), and a unit for the r, and the X and the Y in the coordinates (X, Y) is mm,
the digallium trioxide single crystal substrate comprises either or both of rhodium and iridium,
concentrations of the rhodium and the iridium are both 0.1 mass ppm or less by glow discharge mass spectrometry,
specific resistance of the digallium trioxide single crystal substrate, as measured at 25°C through Hall measurement by Van der Pauw method, is 1.0 × 10⁻³ Ω·cm or more and 2.0 Ω·cm or less,
a carrier concentration in the digallium trioxide single crystal substrate, as measured at 25°C through Hall measurement by Van der Pauw method, is 4.0 × 10¹⁷ cm⁻³ or more and 1.4 × 10¹⁹ cm⁻³ or less, and
electron mobility of the digallium trioxide single crystal substrate, as measured at 25°C through Hall measurement by Van der Pauw method, is 0.2 cm²/V·s or more and 15000 cm²/V·s or less.
